(19) Europäisches Patentamt / European Patent Office / Office européen des brevets

(11) **EP 1 873 815 A1**

(12) **EUROPEAN PATENT APPLICATION**
published in accordance with Art. 153(4) EPC

(43) Date of publication:
**02.01.2008 Bulletin 2008/01**

(51) Int Cl.:
***H01L 21/027*** (2006.01)  ***G03F 7/20*** (2006.01)

(21) Application number: **06730757.9**

(86) International application number:
**PCT/JP2006/306809**

(22) Date of filing: **31.03.2006**

(87) International publication number:
**WO 2006/106907 (12.10.2006 Gazette 2006/41)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **31.03.2005 JP 2005100691**

(71) Applicant: **NIKON CORPORATION**
**Tokyo 100-8331 (JP)**

(72) Inventor: **NAGASAKA, Hiroyuki,**
**NIKON CORPORATION**
**Chiyoda-ku,**
**Tokyo 1008331 (JP)**

(74) Representative: **HOFFMANN EITLE**
**Patent- und Rechtsanwälte**
**Arabellastraße 4**
**D-81925 München (DE)**

(54) **EXPOSURE APPARATUS, EXPOSURE METHOD, AND DEVICE PRODUCTION METHOD**

(57)     An exposure apparatus includes a liquid supply unit which supplies a liquid to fill an optical path space K1 for an exposure light beam therewith, a first land surface 75 which is opposed to a surface of a substrate arranged at an exposure position and which surrounds the optical path space K1 for the exposure light beam, and second land surfaces 76 which are arranged outside the first land surface 75. The first land surface 75 is capable of retaining the liquid between the surface of the substrate and the first land surface 75. The second land surface 76 is provided to make no contact with a film of the liquid existing between the second land surface 76 and the surface of the substrate. Accordingly, the exposure apparatus is provided, in which the optical path space for the exposure light beam can be filled with the liquid in a desired state even when the exposure is performed while moving the substrate.

Fig. 5

**Description**

TECHNICAL FIELD

The present invention relates to an exposure apparatus, an exposure method, and a method for producing a device, in which a substrate is exposed through a liquid.

BACKGROUND ART

An exposure apparatus, which projects a pattern formed on a mask onto a photosensitive substrate to perform the exposure, is used in the photolithography step as one of the steps of producing microdevices such as semiconductor devices and liquid crystal display devices. The exposure apparatus includes a mask stage which is movable while holding the mask and a substrate stage which is movable while holding the substrate. The image of the pattern of the mask is projected onto the substrate via a projection optical system while successively moving the mask stage and the substrate stage. In the microdevice production, it is required to realize a fine and minute pattern to be formed on the substrate in order to achieve a high density of the device. In order to respond to this requirement, it is demanded to realize a higher resolution of the exposure apparatus. A liquid immersion exposure apparatus, in which the optical path space for the exposure light beam is filled with a liquid to expose the substrate through the liquid, has been contrived as one of means to realize the high resolution, as disclosed in International Publication No. 99/49504.

DISCLOSURE OF THE INVENTION

Task to Be Solved by the Invention:

As for the exposure apparatus, it is demanded to realize a high movement velocity of the substrate (substrate stage) in order to improve, for example, the productivity of the device. However, when the substrate (substrate stage) is moved at a high velocity, the following possibility arises. That is, it is difficult to fill the optical path space for the exposure light beam with the liquid in a desired state. Further, there is such a possibility that the exposure accuracy and the measurement accuracy, which are to be obtained through the liquid, may be deteriorated. For example, as the velocity of the movement of the substrate (substrate stage PST) is increased to be high, the following inconvenience arises. That is, it is impossible to sufficiently fill the optical path space for the exposure light beam with the liquid, and the bubble is formed in the liquid. If the inconvenience arises as described above, then the exposure light beam does not arrive at the surface of the substrate satisfactorily, the pattern is not formed on the substrate, and any defect appears in the pattern formed on the substrate. Further, when the velocity of the movement of the substrate (substrate stage PST) is increased to be high, another possibility arises such that the liquid, with which the optical path space is filled, may cause any leakage as well. If the liquid causes the leakage, for example, the corrosion and the trouble of peripheral members and equipment are caused. For example, if the leaked liquid and the unsuccessfully recovered liquid remain as liquid droplets on the substrate, there is also such a possibility that the liquid adhesion trace (so-called water mark) may be formed on the substrate due to the vaporization of the remaining liquid (liquid droplets). The heat of vaporization of the leaked liquid may cause the thermal deformation of, for example, the substrate and the substrate stage as well as the fluctuation of the environment (for example, the humidity and the cleanness) in which the exposure apparatus is placed. It is feared that the exposure accuracy, which includes, for example, the pattern overlay accuracy on the substrate, may be consequently deteriorated, and the various measurement accuracies, which are based on the use of, for example, the interferometer, may be consequently deteriorated. If the substrate, on which the liquid remains (adheres), is unloaded out of the substrate stage, it is feared that the liquid may be also adhered to the transport system for retaining the substrate, and the damage may be expanded. As the velocity of the movement of the substrate (substrate stage) is increased to be high, there is such a possibility that the liquid immersion area, which is filled with the liquid, may be enormously expanded. As a result, it is feared that the entire exposure apparatus may be enormously large-sized as well.
The present invention has been made taking the foregoing circumstances into consideration, an object of which is to provide an exposure apparatus, an exposure method, and a method for producing a device based on the use of them, wherein the optical path space for the exposure light beam can be filled with a liquid in a desired state.

Solution for the Task:

In order to achieve the object as described above, the present invention adopts the following constructions corresponding to respective drawings as illustrated in embodiments. However, parenthesized symbols affixed to respective elements merely exemplify the elements by way of example, with which it is not intended to limit the respective elements.

According to a first aspect of the present invention, there is provided an exposure apparatus (EX) which exposes a substrate (P) by radiating an exposure light beam (EL) onto the substrate (P); the exposure apparatus including a liquid supply unit (11) which supplies a liquid (LQ) to fill an optical path space (K1) for the exposure light beam (EL) with the liquid (LQ); a first surface (75) which is provided to surround the optical path space (K1) for the exposure light beam (EL), which is arranged opposite to a surface of an object (P) arranged at a position capable of being irradiated with the exposure light beam (EL), and between which and the object (P) the liquid (LQ) supplied from the liquid supply unit (11) can be retained; and a second surface (76) which is provided outside the first surface (75) with respect to the optical path space (K1) for the exposure light beam (EL), and which is arranged opposite to the surface of the object (P); wherein the second surface (76) is provided to prevent a film of the liquid (LQ), which exists between the surface of the object (P) and the second surface (75), from making contact with the second surface (76).

According to the first aspect of the present invention, the optical path space for the exposure light beam can be filled with the liquid in a desired state even when the exposure is performed while moving the substrate in a predetermined direction.

According to a second aspect of the present invention, there is provided an exposure apparatus which exposes a substrate (P) by radiating an exposure light beam (EL) onto the substrate (P) through a liquid (LQ); the exposure apparatus including a member (70) which is opposite to a surface of an object (P) arranged at a position capable of being irradiated with the exposure light beam (EL), and between which and the object (P) the liquid (LQ) can be retained; and a recovery section (22) which recovers the liquid (LQ) retained between the object (P) and the member (70), wherein a space-forming area (72, 76), which is positioned to be opposite to the surface of the object and is positioned between an optical path (K1) and the recovery section (22), and which provides a space (SP) between the member (70) and the liquid (LQ) on the object (P), is formed at the member.

According to the second aspect of the present invention, a predetermined portion of the optical path for the exposure light beam can be filled with the liquid while suppressing the enormous expansion of the liquid immersion area and the leakage of the liquid.

According to a third aspect of the present invention, there is provided an exposure method for exposing a substrate (P) by radiating an exposure light beam (EL) onto the substrate (P) through a liquid (LQ); the exposure method comprising supplying the liquid (LQ) to a space between the substrate (P) and a member (70) arranged to be opposite to the substrate; recovering the liquid (LQ) while providing a space (SP) between the member (70) and the liquid (LQ) on the substrate (P); and exposing the substrate by radiating the exposure light beam onto the substrate (P) through the liquid (LQ).

According to the third aspect of the present invention, the substrate can be exposed in a state in which a predetermined portion of the optical path for the exposure light beam is filled with the liquid while suppressing the enormous expansion of the liquid immersion area and the leakage of the liquid.

According to a fourth aspect of the present invention, there is provided a method for producing a device, including exposing (204) a substrate (P) by using the exposure apparatus (EX) as defined in the first or second aspect, developing (204) the exposed substrate, and processing (205) the developed substrate.

According to a fifth aspect of the present invention, there is provided a method for producing a device, comprising exposing (204) a substrate (P) by using the exposure method as defined in the third aspect, developing (204) the exposed substrate (P), and processing (205) the developed substrate.

According to the fourth and fifth aspects of the present invention, it is possible to produce the device by using the exposure apparatus and the exposure method as described above which make it possible to fill the optical path space for the exposure light beam with the liquid in a desired state.

Effect of the Invention:

According to the present invention, it is possible to fill the optical path space for the exposure light beam with the liquid in a desired state, and it is possible to satisfactorily perform the exposure process and the measurement process through the liquid.

BRIEF DESCRIPTION OF THE DRAWINGS

Fig. 1 shows a schematic arrangement illustrating an exposure apparatus according to a first embodiment.

Fig. 2 shows, with partial cutout, a schematic perspective view illustrating those disposed in the vicinity of a nozzle member 70 according to the first embodiment.

Fig. 3 shows a perspective view illustrating the nozzle member 70 according to the first embodiment as viewed from the lower side.

Fig. 4 shows a side sectional view taken in parallel to the XZ plane as shown in Fig. 2.

Fig. 5 shows a side sectional view taken in parallel to the YZ plane as shown in Fig. 2.

Fig. 6 illustrates the principle of the liquid recovery operation performed by a liquid immersion mechanism.

Figs. 7A and 7B schematically illustrate the behavior of the liquid in accordance with the movement of the substrate.

Fig. 8 illustrates the behavior of the liquid in accordance with the movement of the substrate according to the first embodiment.

Fig. 9 illustrates the behavior of the liquid in accordance with the movement of the substrate according to the first embodiment.

Fig. 10 illustrates the behavior of the liquid in accordance with the movement of the substrate according to a second embodiment.

Fig. 11 shows a perspective view illustrating a nozzle member 70 according to a third embodiment as viewed from the lower side.

Fig. 12 shows a side sectional view taken in parallel to the YZ plane as shown in Fig. 11.

Fig. 13 shows a flow chart illustrating exemplary steps of producing a microdevice.

Parts List:

1: liquid immersion mechanism, 11: liquid supply unit, 12: supply port, 16: gas discharge port, 22: recovery port, 25: porous member, 50: fin member, 51: wall, 75: first land surface, 76: second land surface, 77: upper surface, EL: exposure light beam, EX: exposure apparatus, G2: internal space, K1: optical path space, K3: external space, LS1: final optical element, P: substrate, PL: projection optical system.

BEST MODE FOR CARRYING OUT THE INVENTION

Embodiments of the present invention will be explained below with reference to the drawings. However, the present invention is not limited thereto.

First Embodiment

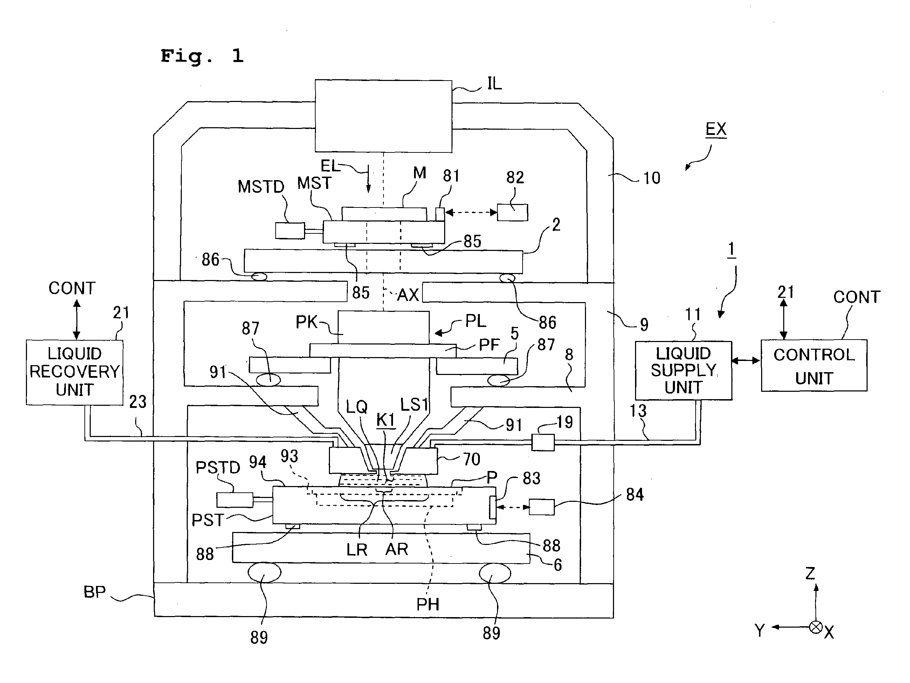

Fig. 1 shows a schematic arrangement illustrating an exposure apparatus according to a first embodiment. With reference to Fig. 1, the exposure apparatus EX includes a mask stage MST which is movable while holding a mask M, a substrate stage PST which is movable while holding a substrate P, an illumination optical system IL which illuminates, with an exposure light beam EL, the mask M held by the mask stage MST, a projection optical system PL which projects an image of a pattern of the mask M illuminated with the exposure light beam EL onto the substrate P held by the substrate stage PST, and a control unit CONT which integrally controls the operation of the entire exposure apparatus EX.
The exposure apparatus EX of the embodiment of the present invention is the liquid immersion exposure apparatus in which the liquid immersion method is applied in order that the exposure wavelength is substantially shortened to improve the resolution and the depth of focus is substantially widened. The exposure apparatus EX includes a liquid immersion mechanism 1 which is provided to fill, with a liquid LQ, an optical path space K1 for the exposure light beam EL disposed in the vicinity of the image plane of the projection optical system PL. The liquid immersion mechanism 1 has a nozzle member 70 which is provided in the vicinity of the optical path space K1 and which has supply ports 12 for supplying the liquid LQ and a recovery port 22 for recovering the liquid LQ, a liquid supply unit 11 which supplies the liquid LQ via a supply tube 13 and the supply ports 12 provided for the nozzle member 70, and a liquid recovery unit 21 which recovers the liquid LQ via a recovery tube 23 and the recovery port 22 provided at the nozzle member 70. As described in detail later on, a flow passage (supply flow passage) 14, which connects the supply port 12 and the supply tube 13, is provided in the nozzle member 70. Further, a flow passage (recovery flow passage) 24, which connects the recovery port 22 and the recovery tube 23, is provided in the nozzle member 70. The supply port, the recovery port, the supply flow passage, and the recovery flow passage are not shown in Fig. 1. The nozzle member 70 is formed to have an annular shape to surround a final optical element LS1 which is closest to the image plane of the projection optical system PL and which is included in a plurality of optical elements for constructing the projection optical system PL.

The exposure apparatus EX of this embodiment adopts the local liquid immersion system in which a liquid immersion area LR of the liquid LQ is locally formed on a part of the substrate P including a projection area AR of the projection optical system PL, the liquid immersion area LR being larger than the projection area AR and smaller than the substrate P. The exposure apparatus EX transfers the pattern of the mask M to the substrate P by radiating, onto the substrate P, the exposure light beam EL allowed to pass through the mask M via the projection optical system PL and the liquid LQ with which the optical path space K1 is filled, while the optical path space K1 for the exposure light beam EL, which is disposed between the final optical element LS1 arranged closest to the image plane of the projection optical system PL and the substrate P arranged on the image plane side of the projection optical system PL, is filled with the liquid LQ at least during a period in which the pattern image of the mask M is projected onto the substrate P. The control unit CONT forms the liquid immersion area LR of the liquid LQ locally on the substrate P by filling the optical path space K1 with the liquid LQ such that a predetermined amount of the liquid LQ is supplied by using the liquid supply unit 11 of the liquid supply mechanism 1 and a predetermined amount of the liquid LQ is recovered by using the liquid recovery unit 21.

The following explanation will be made about a case in which the optical path space K1 is filled with the liquid LQ in a state in which the substrate P is arranged at the position capable of being irradiated with the exposure light beam EL, i.e., in a state in which the projection optical system PL and the substrate P are arranged opposite to one another. However, the same can be said in a case in which the optical path space K1 is filled with the liquid LQ in a state in which any object (for example, the upper surface 94 of the substrate stage PST) other than the substrate P is arranged opposite to the projection optical system PL.

The embodiment of the present invention will be explained as exemplified by a case of the use of the scanning type exposure apparatus (so-called scanning stepper) as the exposure apparatus EX in the pattern formed on the mask M is exposed onto the substrate P while synchronously moving the mask M and the substrate P in the scanning direction. In the following explanation, the Y axis direction resides in the synchronous movement direction (scanning direction) for the mask M and the substrate P in the horizontal plane, the X axis direction resides in the direction (non-scanning direction) which is perpendicular to the Y axis direction in the horizontal plane, and the Z axis direction resides in the direction which is perpendicular to the X axis direction and the Y axis direction and which is coincident with the optical axis AX of the projection optical system PL. The directions of rotation (inclination) about the X axis, the Y axis, and the Z axis are designated as $\theta X$, $\theta Y$, and $\theta Z$ directions respectively. The term "substrate" referred to herein includes those obtained by coating a base material such as a semiconductor wafer, for example, with a photosensitive material (photoresist) or a protective film, and the term "mask" includes the reticle on which a device pattern to be subjected to the reduction projection onto the substrate is formed.

The exposure apparatus EX includes a base BP which is provided on the floor surface, and a main column 9 which is installed on the base BP. The main column 9 is formed with an upper stepped section 7 and a lower stepped section 8 which protrude inwardly. The illumination optical system IL is provided so that the mask M, which is held by the mask stage MST, is illuminated with the exposure light beam EL. The illumination optical system IL is supported by a support frame 10 which is fixed to an upper portion of the main column 9.

The illumination optical system IL includes, for example, an optical integrator which uniformizes the illuminance of the light flux radiated from an exposure light source, a condenser lens which collects the exposure light beam EL supplied from the optical integrator, a relay lens system, and a field diaphragm which sets the illumination area on the mask M illuminated with the exposure light beam EL. The predetermined illumination area on the mask M is illuminated with the exposure light beam EL having a uniform illuminance distribution by means of the illumination optical system IL. Those usable as the exposure light beam EL radiated from the illumination optical system IL include, for example, emission line (g-ray, h-ray, i-ray) radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the $F_2$ laser beam (wavelength: 157 nm). In this embodiment, the ArF excimer laser beam is used.

In this embodiment, pure water is used as the liquid LQ. Not only the ArF excimer laser beam but also the emission line (g-ray, h-ray, i-ray) radiated, for example, from a mercury lamp and the far ultraviolet light beam (DUV light beam) such as the KrF excimer laser beam (wavelength: 248 nm) are also transmissive through pure water.

The mask stage MST is movable while holding the mask M. The mask stage MST holds the mask M by means of the vacuum attraction (or the electrostatic attraction). A plurality of gas bearings (air bearings) 85, which are non-contact bearings, are provided on the lower surface of the mask stage MST. The mask stage MST is supported in a non-contact manner with respect to an upper surface (guide surface) of a mask stage supporting plate 2 by means of the air bearings 85. Openings, through which the pattern image of the mask M is allowed to pass, are formed at central portions of the mask stage MST and the mask stage supporting plate 2 respectively. The mask stage supporting plate 2 is supported by the upper stepped section 7 of the main column 9 by the aid of an anti-vibration unit 86. That is, the mask stage MST is supported by the upper stepped section 7 of the main column 9 by the aid of the anti-vibration unit 86 and the mask stage supporting plate 2. The mask stage supporting plate 2 and the main column 9 are separated from each other in view of the vibration by means of the anti-vibration unit 86 so that the vibration of the main column 9 is not transmitted to the mask stage supporting plate 2 which supports the mask stage MST.

The mask stage MST is two-dimensionally movable in the plane perpendicular to the optical axis AX of the projection optical system PL, i.e., in the XY plane, and it is finely rotatable in the θZ direction on the mask stage supporting plate 2 in a state in which the mask M is held, in accordance with the driving operation of the mask stage-driving unit MSTD including, for example, a linear motor controlled by the control unit CONT. A movement mirror 81 is provided on the mask stage MST. A laser interferometer 82 is provided at a position opposite to the movement mirror 82. The position in the two-dimensional direction and the angle of rotation in the θZ direction of the mask M on the mask stage MST are measured in real-time by the laser interferometer 82. It is also allowable that the angles of rotation in the θX, θY directions are measured by the laser interferometer 82. The result of the measurement of the laser interferometer 82 is outputted to the control unit CONT. The control unit CONT drives the mask stage-driving unit MSTD on the basis of the result of the measurement obtained by the laser interferometer 82 to thereby control the position of the mask M held by the mask stage MST.

The projection optical system PL projects the image of the pattern of the mask M onto the substrate P at a predetermined projection magnification β. The projection optical system PL includes a plurality of optical elements. The optical elements are held by a barrel PK. In this embodiment, the projection optical system PL is based on the reduction system having the projection magnification β which is, for example, 1/4, 1/5, or 1/8. The projection optical system PL may be based on any one of the 1x magnification system and the magnifying system. The projection optical system PL may be based on any one of the dioptric system including no catoptric optical element, the catoptric system including no dioptric optical element, and the cata-dioptric system including dioptric and catoptric optical elements. The final optical element LS1, which is closest to the image plane of the projection optical system PL and which is included in the plurality of optical elements for constructing the projection optical system PL, is exposed from the barrel PK.

A flange PF is provided on the outer circumference of the barrel PK which retains the projection optical system PL. The projection optical system PL is supported by a barrel supporting plate 5 by the aid of the flange PF. The barrel supporting plate 5 is supported by the lower stepped section 8 of the main column 9 by the aid of an anti-vibration unit 87. That is, the projection optical system PL is supported by the lower stepped section 8 of the main column 9 by the aid of the anti-vibration unit 87 and the barrel supporting plate 5. The barrel supporting plate 5 is separated from the main column 9 in view of vibration by the anti-vibration unit 87 so that the vibration of the main column 9 is not transmitted to the barrel supporting plate 5 which supports the projection optical system PL.

The substrate stage PST has the substrate holder PH which holds the substrate P. The substrate stage PST is movable while holding the substrate P on the substrate holder PH. The substrate holder PH holds the substrate P, for example, by means of the vacuum attraction. A recess 93 is provided on the substrate stage PST. The substrate holder PH for holding the substrate P is arranged in the recess 93. The upper surface 94 disposed around the recess 93 of the substrate stage PST forms a flat surface which has approximately the same height as that of (is flush with) the surface of the substrate P held by the substrate holder PH. Any difference in height may be provided between the upper surface 94 of the substrate stage PST and the surface of the substrate P held by the substrate holder PH provided that the optical path space K1 can be continuously filled with the liquid LQ.

A plurality of gas bearings (air bearings) 88, which are the non-contact bearings, are provided on the lower surface of the substrate stage PST. The substrate stage PST is supported in a non-contact manner by the air bearings 88 with respect to the upper surface (guide surface) of the substrate stage supporting plate 6. The substrate stage supporting plate 6 is supported on the base BP by the aid of an anti-vibration unit 89. The substrate stage supporting plate 6 is separated from the main column 9 and the base BP (floor surface) in view of vibration by the anti-vibration unit 89 so that the vibration of, for example, the base BP (floor surface) and the main column 9 is not transmitted to the substrate stage supporting plate 6 which supports the substrate stage PST.

The substrate stage PST is two-dimensionally movable in the XY plane, and it is finely rotatable in the θZ direction on the substrate stage supporting plate 6 in a state in which the substrate P is held by the aid of the substrate holder PH, in accordance with the driving operation of the substrate stage-driving unit PSTD including, for example, a linear motor which is controlled by the control unit CONT. Further, the substrate stage PST is also movable in the Z axis direction, the θX direction, and the θY direction. Therefore, the surface of the substrate P held by the substrate stage PST is movable in the directions of six degrees of freedom of the X axis, Y axis, Z axis, θX, θY, and θZ directions. A movement mirror 83 is secured to the side surface of the substrate stage PST. A laser interferometer 84 is provided at a position opposed to the movement mirror 83. The angle of rotation and the position in the two-dimensional direction of the substrate P on the substrate stage PST are measured in real-time by the laser interferometer 84. Although not shown, the exposure apparatus EX is provided with a focus/leveling-detecting system which detects the surface position information about the surface of the substrate P held by the substrate stage PST, as disclosed, for example, in Japanese Patent Application Laid-open No. 2004-207710.

The result of the measurement performed by the laser interferometer 84 is outputted to the control unit CONT. The result of the detection performed by the focus/leveling-detecting system is also outputted to the control unit CONT. The control unit CONT drives the substrate stage-driving unit PSTD on the basis of the detection result of the focus/leveling-detecting system to control the angle of inclination (θX, θY) and the focus position (Z position) of the substrate P so that the control unit CONT adjusts the surface of the substrate P to match the image plane formed via the projection optical system PL and the liquid LQ, and the control unit CONT controls the position of the substrate P in the X axis direction, the Y axis direction, and the θZ direction on the basis of the measurement result of the laser interferometer 84.

The liquid supply unit 11 of the liquid immersion mechanism 1 supplies the liquid LQ in order to fill the optical path space K1 for the exposure light beam EL with the liquid LQ. The liquid supply unit 11 is provided with, for example, a tank for accommodating the liquid LQ, a pressurizing pump, a temperature adjustment unit for adjusting the temperature of the liquid LQ to be supplied, and a filter unit for removing any foreign matter contained in the liquid LQ. One end of the supply tube 13 is connected to the liquid supply unit 11. The other end of the supply tube 13 is connected to the nozzle member 70. The liquid supply operation of the liquid supply unit 11 is controlled by the control unit CONT. It is unnecessary that the exposure apparatus EX is provided with, for example, all of the tank, the pressurizing pump, the temperature adjustment mechanism, and the filter unit of the liquid supply unit 11. It is also allowable to substitutively use any equipment of the factory or the like in which the exposure apparatus EX is installed.

A flow rate controller 19 called "mass flow controller", which controls the amount of the liquid per unit time to be fed from the liquid supply unit 11 and supplied to the image plane side of the projection optical system PL, is provided at an intermediate position of the supply tube 13. The control of the liquid supply amount based on the use of the flow rate controller 19 is performed under the instruction signal of the control unit CONT.

The liquid recovery unit 21 of the liquid immersion mechanism 1 recovers the liquid LQ with which the optical path space K1 for the exposure light beam EL is filled. The liquid recovery unit 21 is provided with, for example, a vacuum system such as a vacuum pump, a gas/liquid separator which separates the gas from the recovered liquid LQ, and a tank for accommodating the recovered liquid LQ. One end of the recovery tube 23 is connected to the liquid recovery unit 21. The other end of the recovery tube 23 is connected to the nozzle member 70. The liquid recovery operation of the liquid recovery unit 21 is controlled by the control unit CONT. It is unnecessary that the exposure apparatus EX is provided with, for example, all of the vacuum system, the gas/liquid separator, and the tank of the liquid recovery unit 21. It is also allowable to substitutively use any equipment of the factory or the like in which the exposure apparatus EX is installed.

The nozzle member 70 is supported by a support mechanism 91. The support mechanism 91 is connected to the lower stepped section 8 of the main column 9. The main column 9, which supports the nozzle member 70 by the aid of the support mechanism 91, is separated in view of vibration by the anti-vibration unit 87 from the barrel supporting plate 5 which supports the barrel PK of the projection optical system PL by the aid of the flange PF. Therefore, the vibration, which is generated on the nozzle member 70, is prevented from being transmitted to the projection optical system PL. The main column 9 is separated in view of vibration by the anti-vibration unit 89 from the substrate stage supporting plate 6 which supports the substrate stage PST. Therefore, the vibration, which is generated on the nozzle member 70, is prevented from being transmitted to the substrate stage PST via the main column 9 and the base BP. Further, the main column 9 is separated in view of vibration by the anti-vibration unit 86 from the mask stage supporting plate 2 which supports the mask stage MST. Therefore, the vibration, which is generated on the nozzle member 70, is prevented from being transmitted to the mask stage MST via the main column 9.

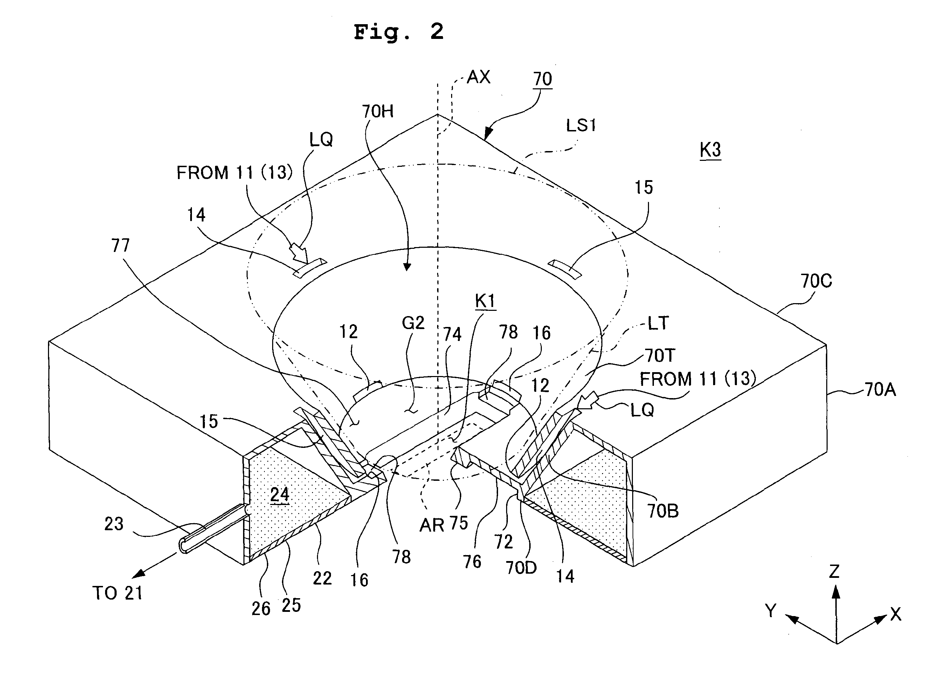

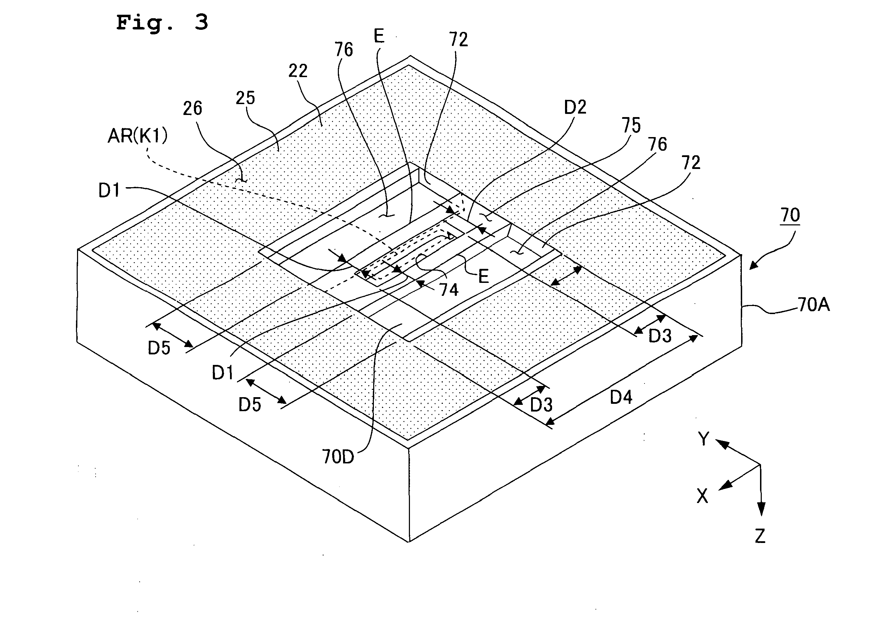

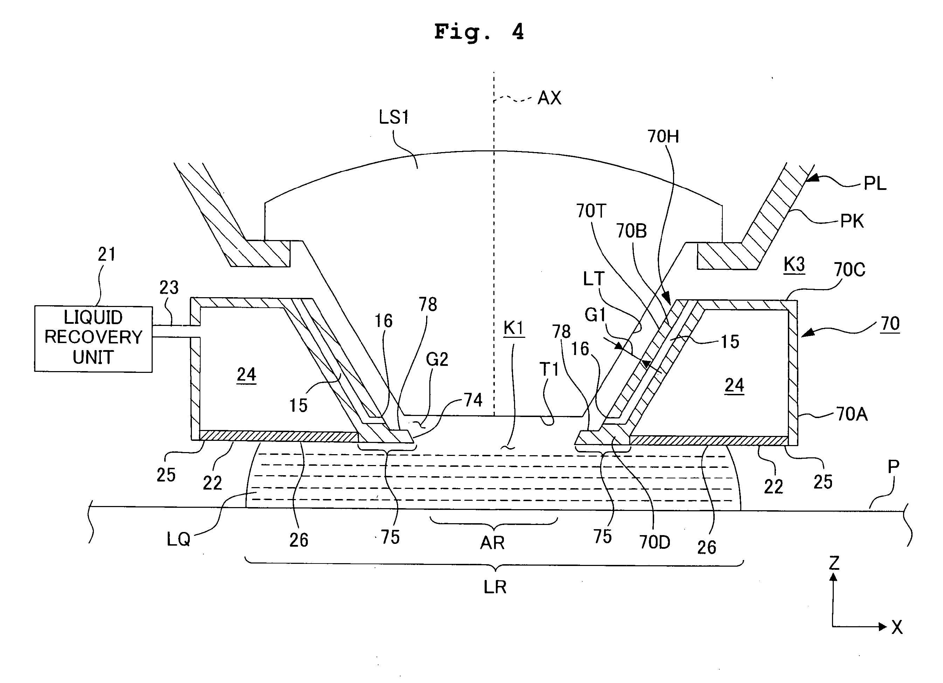

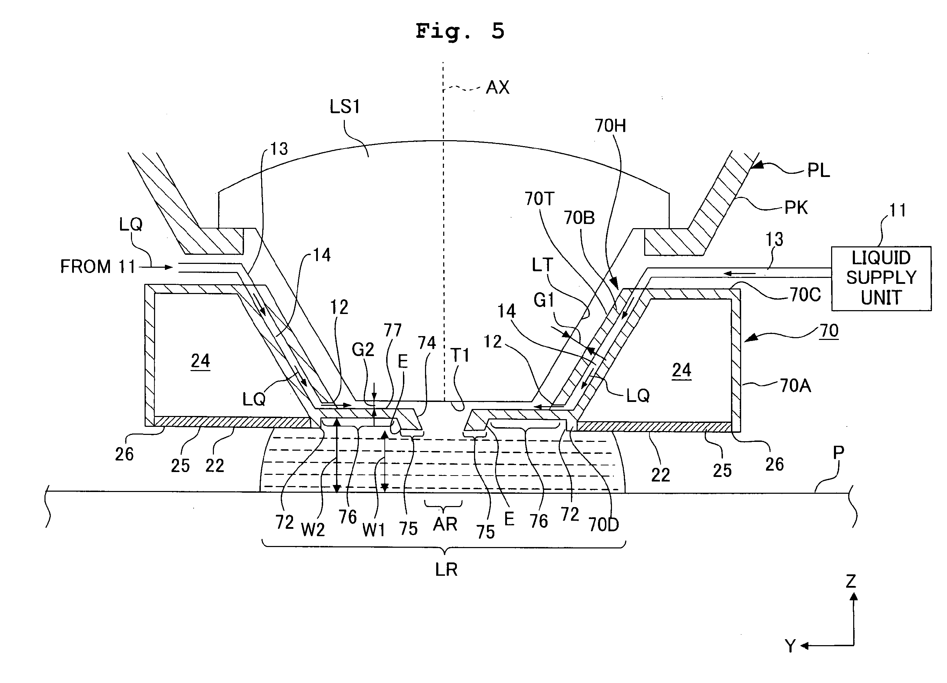

Next, an explanation will be made about the nozzle member 70 with reference to Figs. 2 to 5. Fig. 2 shows, with partial cutout, a schematic perspective view illustrating those disposed in the vicinity of the nozzle member 70. Fig. 3 shows a perspective view illustrating the nozzle member 70 as viewed from the lower side. Fig. 4 shows a side sectional view taken in parallel to the XZ plane. Fig. 5 shows a side sectional view taken in parallel to the YZ plane.

The nozzle member 70 is provided in the vicinity of the final optical element LS1 disposed most closely to the image plane of the projection optical system PL. The nozzle member 70 is the annular member which is provided to surround the final optical element LS1 over the substrate P (substrate stage PST). The nozzle member 70 has a hole 70H which is disposed at a central portion thereof and in which the projection optical system PL (final optical element LS1) can be arranged. In this embodiment, the nozzle member 70 is constructed by combining a plurality of members. The outer shape of the nozzle member 70 is substantially rectangular as viewed in a plan view. The outer shape of the nozzle member 70 is not limited to the rectangular shape as viewed in a plan view. For example, the nozzle member 70 may be circular as viewed in a plan view. The nozzle member 70 may be composed of one material (for example, titanium). Alternatively, for example, the nozzle member 70 may be composed of aluminum, titanium, stainless steel, duralumin, or any alloy containing them.

The nozzle member 70 has a side plate 70A, an inclined plate 70B, a ceiling plate 70C which is provided on the upper ends of the side plate 70A and the inclined plate 70B, and a bottom plate 70D which is opposed to the substrate P (substrate stage PST). The inclined plate 70B is formed to have a mortar-shaped form. The final optical element LS1 is arranged inside the hole 70H formed by the inclined plate 70B. The inner side surface 70T of the inclined plate 70B (i.e., the inner side surface of the hole 70H of the nozzle member 70) is opposed to the side surface LT of the final optical element LS1 of the projection optical system PL. A predetermined gap G1 is provided between the inner side surface 70T of the inclined plate 70B and the side surface LT of the final optical element LS1. Owing to the provision of the gap G1, the vibration, which is generated on the nozzle member 70, is prevented from being directly transmitted to the projection optical system PL (final optical element LS1). The inner side surface 70T of the inclined plate 70B is liquid-repellent (water-repellent) with respect to the liquid LQ. The inflow is suppressed for the liquid LQ into the gap G1 between the side surface LT of the final optical element LS1 of the projection optical system PL and the inner side surface 70T of the inclined plate 70B. The liquid-repelling treatment, which is adopted to allow the inner side surface 70T of the inclined plate 70B to be liquid-repellent, includes, for example, treatments for applying or adhering any liquid-repellent material including, for example, a fluorine-based resin material such as polytetrafluoroethylene (Teflon, trade name), an acrylic resin material, and a silicon-based resin material.

A part of the bottom plate 70D is provided between the substrate P (substrate stage PST) and the lower surface T1 of the final optical element LS1 of the projection optical system PL in relation to the Z axis direction. An opening 74, through which the exposure light beam EL is allowed to pass, is formed at a central portion of the bottom plate 70D. The opening 74 is formed so that the exposure light beam EL, which is allowed to pass through the final optical element (optical member) LS1 of the projection optical system PL, passes therethrough. In this embodiment, the projection area AR, which is irradiated with the exposure light beam EL, is provided to be slit-shaped (substantially rectangular), in which the X axis direction (non-scanning direction) is the longitudinal direction. The opening 74 has the shape adapted to the projection area AR. In this embodiment, the opening 74 is formed to be slit-shaped (substantially rectangular), in which the X axis direction (non-scanning direction) is the longitudinal direction. The opening 74 is formed to be larger than the projection area AR. The exposure light beam EL, which has passed through the projection optical system PL, can arrive at the surface of the substrate P without being shielded by the bottom plate 70D.

The lower surface of the nozzle member 70, which is opposed to the substrate P (substrate stage PST), has a first surface 75 which is opposed to the surface of the substrate P arranged at the position capable of being irradiated with the exposure light beam EL. The first surface 75 is a flat surface which is parallel to the XY plane. The first surface 75 is provided to surround the optical path space K1 for the exposure light beam EL (The exposure light beam, which is allowed to pass through the space, is radiated onto the substrate P to form the projection area AR. In this specification, it is intended that the "optical path space K1" is the space through which the exposure light beam passes. In this embodiment and in the following embodiments, the "optical path space K1" means the space through which the exposure light beam passes between the final optical element LS1 and the substrate P). That is, the first surface 75 is the surface provided to surround the opening 74 of the bottom plate 70D through which the exposure light beam EL is allowed to pass. The phrase "position capable of being irradiated with the exposure light beam EL" herein includes the position opposed to the projection optical system PL. The first surface 75 is provided to surround the optical path space K1 for the exposure light beam EL allowed to pass through the projection optical system PL. Therefore, the control unit CONT is capable of allowing the first surface 75 and the surface of the substrate P to be opposed to one another by arranging the substrate P at the position capable of being irradiated with the exposure light beam EL.

The surface of the substrate P held by the substrate stage PST is substantially parallel to the XY plane. Therefore, the first surface 75 of the nozzle member 70 is provided so that the first surface 75 is opposed to the surface of the substrate P held by the substrate stage PST, and the first surface 75 is substantially parallel to the surface of the substrate P (XY plane). The first surface 75 is capable of retaining the liquid LQ between the first surface 75 and the substrate P, the liquid LQ being supplied from the liquid supply unit 11 in order to fill the optical path space K1 for the exposure light beam EL therewith. In the following description, the first surface (flat surface) 75 of the nozzle member 70, which is provided to be opposed to the surface of the substrate P held by the substrate stage PST, which is provided to surround the optical path space K1 for the exposure light beam EL, and which is formed to be substantially parallel to the surface of the substrate P (XY plane), is appropriately referred to as "first land surface 75".

The first land surface 75 is provided at the position on the nozzle member 70 to be disposed most closely to the substrate P held by the substrate stage PST. That is, the first land surface 75 resides in the portion at which the distance (spacing distance) between the first land surface 75 and the surface of the substrate P held by the substrate stage PST is shortest. Accordingly, the liquid LQ can be satisfactorily retained between the first land surface 75 and the substrate P to form the liquid immersion area LR. In this embodiment, the distance (spacing distance) W1 between the surface of the substrate P and the first land surface 75 is set to be about 1 mm.

The first land surface 75 is provided to surround the optical path space K1 for the exposure light beam EL (projection area AR) between the substrate P and the lower surface T1 of the projection optical system PL. The first land surface 75 is provided in a partial area of the lower surface of the nozzle member 70 (bottom plate 70D). As described above, the first land surface 75 is provided to surround the opening 74 through which the exposure light beam EL is allowed to pass. The first land surface 75 has the shape adapted to the opening 74. In this embodiment, the outer shape of the first land surface 75 is formed to be rectangular, in which the X axis direction (non-scanning direction) is the longitudinal direction.

The opening 74 is provided at a substantially central portion of the first land surface 75. As shown in Fig. 3, for example, the width D1 of the first land surface 75 in the Y axis direction (scanning direction) is smaller than the width D2 of the opening 74 in the Y axis direction. In this embodiment, the width D1 of the first land surface 75 in the Y axis direction is the distance between the +Y side (-Y side) end (edge) E of the first land surface 75 and the +Y side (-Y side) end (edge) of the opening 74. In this embodiment, the opening 74 is provided at the substantially central portion of the first land surface 75. Therefore, the distance between the +Y side end E of the first land surface 75 and the +Y side end of the opening 74 is approximately equal to the distance between the -Y side end E of the first land surface 75 and the -Y side end of the opening 74.

In this embodiment, the width D1 of the first land surface 75 in the Y axis direction is smaller than the width D3 of the first land surface 75 in the X axis direction. In this embodiment, the width D3 of the first land surface 75 in the X axis direction is the distance between the +X side (-X side) end (edge) of the first land surface 75 and the +X side (-X side) end (edge) of the opening 74. In this embodiment, the opening 74 is provided at the substantially central portion of the first land surface 75. Therefore, the distance between the +X side end of the first land surface 75 and the +X side end of the opening 74 is approximately equal to the distance between the -X side end of the first land surface 75 and the -X side end of the opening 74.

The distance between the surface of the substrate P and the lower surface T1 of the final optical element LS1 is longer than the distance between the surface of the substrate P and the first land surface 75. That is, the lower surface T1 of the final optical element LS1 is formed at the position higher than that of the first land surface 75. The bottom plate 70D is provided to make no contact with the lower surface T1 of the final optical element LS1 and the substrate P (substrate stage PST). As shown in Fig. 5, for example, the space having a predetermined gap G2 is formed between the lower surface T1 of the final optical element LS1 and the upper surface 77 of the bottom plate 70D. The upper surface 77 of the bottom plate 70D is provided to surround the opening 74 through which the exposure light beam EL is allowed to pass. That is, the upper surface 77 of the bottom plate 70D is provided to surround the optical path space K1 for the exposure light beam EL, and provided to be opposed to the final optical element LS1 with the predetermined gap G2 being between the upper surface 77 and the final optical element LS1. In the following description, the space, which is disposed inside the nozzle member 70 and which includes the space between the lower surface T1 of the final optical element LS1 and the upper surface 77 of the bottom plate 70D, is appropriately referred to as "internal space G2".

Recesses 72 (space-forming areas) are provided on the both sides in the Y axis direction with respect to the first land surface 75 on the lower surface of the nozzle member 70 respectively. The recess 72 is depressed or recessed so that the recess 72 is away from the surface of the substrate P held by the substrate stage PST. Second surfaces 76, which are opposed to the substrate P held by the substrate stage PST, are formed inside the recesses 72. The second surfaces 76 are arranged outside the first land surface 75 with respect to the optical path space K1 for the exposure light beam EL. The second surfaces 76 are away farther from the surface of the substrate P held by the substrate stage PST as compared with the first land surface 75. In the following description, the second surface 76 of the nozzle member 70, which is arranged outside the first land surface 75 with respect to the optical path space K1 for the exposure light beam EL so that the second surface 76 is opposed to the surface of the substrate P retained by the substrate stage PST and which is separated farther from the surface of the substrate P as compared with the first land surface 75, is appropriately referred to as "second land surface 76".

In this embodiment, the second land surface 76 is a flat surface which is substantially parallel to the surface of the substrate P held by the substrate stage PST. In this embodiment, the distance (spacing distance) W2 between the surface of the substrate P and the second land surface 76 is set to be about 3 mm. For example, the scales in the respective drawings are different from those actually provided, in order to depict the drawings more comprehensively.

The second land surfaces 76 are provided on the both sides of the first land surface 75 in the Y axis direction (scanning direction) respectively. As shown in Fig. 5, for example, the outer shape of the second land surface 76 is rectangular, in which the X axis direction (non-scanning direction) is the longitudinal direction in this embodiment. The size of the second land surface 76 in the X axis direction and the entire size of the first land surface 75 in the X axis direction have approximately identical values D4. In this embodiment, the +Y side edge E of the first land surface 75 is formed to be linear to extend in the X axis direction as viewed in a plan view. The -Y side edge E is also formed to be linear to extend in the X axis direction as viewed in a plan view.

The liquid LQ, with which the optical path space K1 is filled, makes contact with the first land surface 75. The liquid LQ, with which the optical path space K1 is filled, also makes contact with the lower surface T1 of the final optical element LS1. That is, the first land surface 75 of the nozzle member 70 and the lower surface T1 of the final optical element LS1 are the liquid contact surfaces to make contact with the liquid LQ respectively.

On the other hand, as described later on, the second land surface 76 is provided to prevent the film of the liquid LQ, which exists between the surface of the substrate P and the second land surface 76, from making contact with the second land surface 76. That is, even when the liquid LQ is allowed to make contact with the first land surface 75 in order to fill the optical path space K1 with the liquid LQ so that the liquid LQ is retained between the first land surface 75 and the substrate P, the film of the liquid LQ, which exists between the surface of the substrate P and the second land surface 76, does not make any contact with the second land surface 76. In other words, the space, in which no liquid exists, is provided between the second land surface 76 and the liquid LQ (surface of the liquid LQ) existing on the substrate P opposed to the second land surface 76, owing to the presence of the recess 72 (space-forming area) which defines the second land surface 76.

The first land surface 75 is liquid-attractive with respect to the liquid LQ. In this embodiment, the bottom plate 70D, which forms the first land surface 75, is formed of titanium. A passive film having the photocatalytic function is formed on the surface of the titanium material, and it is possible to maintain the liquid-attracting property (water-attracting property) of the surface. Therefore, the contact angle of the liquid LQ on the first land surface 75 can be maintained to be, for example, not more than 20°.

Each of the first land surface 75 and the second land surfaces 76 may be formed of stainless steel (for example, SUS 316). The surface may be applied with a surface treatment to suppress the elution of any impurity into the liquid LQ, or a surface treatment to enhance the liquid-attracting property. Such a surface treatment includes, for example, a treatment in which chromium oxide is deposited or adhered onto the first land surface 75 and the second land surfaces 76 respectively. For example, there are exemplified the "GOLDEP" treatment or the "GOLDEP WHITE" treatment available from Kobelco Eco-Solutions Co., Ltd.

On the other hand, the second land surface 76 is liquid-repellent with respect to the liquid LQ. In this embodiment, the surface treatment (liquid-repelling treatment), which provides the liquid repellence with respect to the liquid LQ, is performed to the second land surfaces 76. Such a surface treatment includes, for example, treatments for applying or adhering any liquid-repellent material including, for example, a fluorine-based resin material such as polytetrafluoroethylene (Teflon, trade name), an acrylic resin material, and a silicon-based resin material.

The nozzle member 70 includes the supply ports 12 which supplies the liquid LQ to fill the optical path space K1 for the exposure light beam EL therewith, and the recovery port 22 which recovers the liquid LQ having been supplied to fill the optical path space K1 for the exposure light beam EL therewith. The nozzle member 70 further includes the supply flow passages 14 connected to the supply ports 12 and the recovery flow passage 24 connected to the recovery port 22. Although not shown or simplified in Figs. 2 to 5, the supply flow passage 14 is connected to the other end of the supply tube 13, and the recovery flow passage 24 is connected to the other end of the recovery tube 23.

The supply flow passage 14 is formed by a slit-shaped through-hole which penetrates in the inclined direction through the inclined plate 70B of the nozzle member 70. In this embodiment, the supply flow passages 14 are provided on the both sides in the Y axis direction with respect to the optical path space K1 (projection area AR) respectively. The upper end of the supply flow passage (through-hole) 14 is connected to the other end of the supply tube 13. Accordingly, the supply flow passage 14 is connected to the liquid supply unit 11 via the supply tube 13. On the other hand, the lower end of the supply flow passage 14 is provided in the vicinity of the internal space G2 between the lower surface T1 of the final optical element LS1 and the upper surface 77 of the bottom plate 70D. The lower end of the supply flow passage 14 is the supply port 12. That is, the supply port 12 is provided in the vicinity of the internal space G2 between the lower surface T1 of the final optical element LS1 and the upper surface 77 of the bottom plate 70D, which is connected to the internal space G2. In this embodiment, the supply ports 12 are provided at the respective predetermined positions disposed on the both sides in the Y axis direction with the optical path space K1 intervening therebetween outside the optical path space K1 for the exposure light beam EL.

The supply port 12 supplies the liquid LQ in order to fill the optical path space K1 therewith. The liquid LQ is supplied from the liquid supply unit 11 to the supply port 12. The supply port 12 is capable of supplying the liquid LQ to the space between the lower surface T1 of the final optical element LS1 and the upper surface 77 of the bottom plate 70D, i.e., the internal space G2. The optical path space K1 for the exposure light beam EL, which is disposed between the final optical element LS1 and the substrate P, is filled with the liquid LQ by supplying the liquid LQ from the supply ports 12 to the internal space G2 disposed between the final optical element LS1 and the bottom plate 70D.

The nozzle member 70 includes the gas discharge ports 16 which make communication between the internal space G2 and the external space K3. The gas discharge flow passages 15 are connected to the gas discharge ports 16. The gas discharge flow passage 15 is formed by a slit-shaped through-hole which penetrates in the inclined direction through the inclined plate 70B of the nozzle member 70. In this embodiment, the gas discharge flow passages 15 are provided on the both sides in the X axis direction with respect to the optical path space K1 (projection area AR) respectively. The upper end of the gas discharge flow passage (through-hole) 15 is connected to the external space (atmospheric space) K3, which is in a state of being open to the atmospheric air. On the other hand, the lower end of the gas discharge flow passage 15 is connected to the internal space G2 disposed between the lower surface T1 of the final optical element LS1 and the upper surface 77 of the bottom plate 70D. The lower end of the gas discharge flow passage 15 is the gas discharge port 16. That is, the gas discharge port 16 is provided in the vicinity of the internal space G2 disposed between the lower surface T1 of the final optical element LS1 and the upper surface 77 of the bottom plate 70D, which is connected to the internal space G2. In this embodiment, the gas discharge ports 16 are provided at the respective predetermined positions disposed on the both sides in the X axis direction with the optical path space K1 intervening therebetween outside the optical path space K1 for the exposure light beam EL. In this embodiment, a recess 78 is provided in the vicinity of the gas discharge port 16 disposed on the upper surface 77 of the bottom plate 70D. The gas discharge port 16 makes communication between the internal space G2 and the external space K3 via the gas discharge flow passage 15. Therefore, the gas in the internal space G2 can be discharged (evacuated) to the external space K3 from the upper end of the gas discharge flow passage 15 via the gas discharge port 16.

The nozzle member 70 has the space 24 which is open downwardly between the side plate 70A and the inclined plate 70B. The recovery port 22 is provided at the opening of the space 24. The space 24 constitutes at least a part of the recovery flow passage in the nozzle member 70. The other end of the recovery tube 23 is connected to a part of the recovery flow passage (space) 24.

The recovery port 22 recovers the liquid LQ supplied to fill the optical path space K1 therewith. The recovery port 22 is provided at the position opposite to the surface of the substrate P over the substrate P held by the substrate stage PST. The recovery port 22 is away by a predetermined distance from the surface of the substrate P. The recovery port 22 is provided outside the supply ports 12 in relation to the optical path space K1 disposed in the vicinity of the image plane of the projection optical system PL.

The recovery port 22 is provided outside the second land surfaces 76 with respect to the optical path space K1. In this embodiment, the recovery port 22 is provided in an annular form as viewed in a plan view to surround the first land surface 75 and the second land surfaces 76. When the recovery port 22 is provided in the annular form to surround the first land surface 75 and the second land surfaces 76, it is possible to sufficiently suppress, for example, the leakage and the remaining of the liquid LQ.

The nozzle member 70 includes a porous member 25 which has a plurality of holes or pores and which is arranged to cover the recovery port 22. The porous member 25 may be composed of a mesh member having a plurality of holes. The porous member 25 may be composed of, for example, a mesh member formed with a honeycomb pattern including a plurality of substantially hexagonal holes. The porous member 25 can be formed, for example, such that the hole-forming processing is performed to a plate member as a base material for the porous member composed of, for example, titanium or stainless steel (for example, SUS 316). Alternatively, a porous member made of ceramics can be also used as the porous member 25. In this embodiment, the porous member 25 is formed to have a thin plate-shaped form. The porous member 25 has, for example, a thickness of about 100 $\mu$m.

The porous member 25 has the lower surface 26 which is opposed to the substrate P held by the substrate stage PST. The lower surface 26 of the porous member 25 is a part of the lower surface of the nozzle member 70. The lower surface 26 of the porous member 25, which is opposed to the substrate P, is substantially flat. The porous member 25 is provided at the recovery port 22 so that the lower surface 26 is substantially parallel to the surface of the substrate P held by the substrate stage PST (i.e., the XY plane).

The distance between the lower surface 26 of the porous member 25 and the surface of the substrate P is approximately equal to the distance between the first land surface 75 and the surface of the substrate P. That is, the lower surface 26 of the porous member 25 provided at the recovery port 22 is disposed at approximately the same position (height) as that of the first land surface 75 with respect to the surface of the substrate P. The porous member 25, which is provided at the recovery port 22, makes contact with the liquid LQ when the liquid LQ is recovered. The recovery port 22 is capable of recovering the liquid LQ allowed to make contact with the porous member 25. The recovery port 22 and the porous member 25 arranged at the recovery port 22 are formed to have the rectangular annular form as viewed in a plan view.

In this embodiment, the porous member 25 is liquid-attractive (water-attractive) with respect to the liquid LQ. The liquid-attracting treatment (surface treatment), which is performed to make the porous member 25 to be liquid-attractive, includes, for example, a treatment in which chromium oxide is deposited or adhered onto the porous member 25. Specifically, there are exemplified the "GOLDEP" treatment or the "GOLDEP WHITE" treatment as described above. When such a surface treatment is performed, it is possible to suppress the elution of any impurity from the porous member 25 to the liquid LQ. It is of course allowable that the porous member 25 is formed of a liquid-repellent material itself.

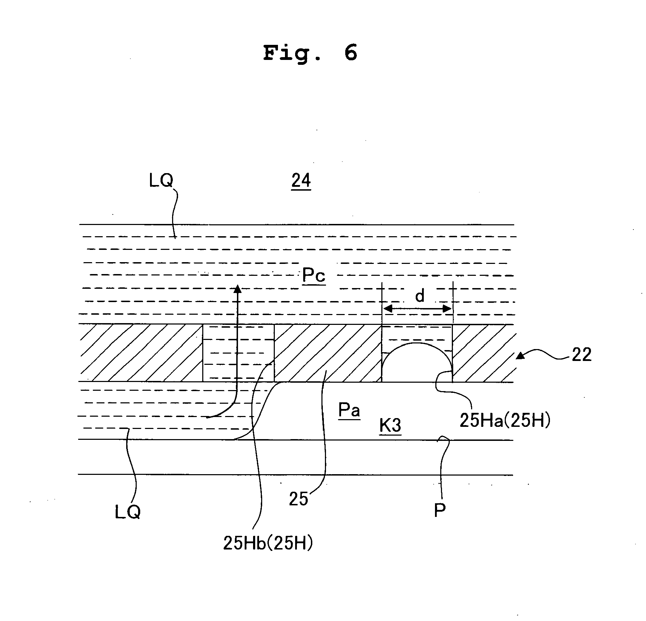

Next, an explanation will be made with reference to Fig. 6 about the principle of the liquid recovery operation by the liquid immersion mechanism 1 in this embodiment. Fig. 6 shows, with magnification, a sectional view illustrating a part of the porous member 25, which schematically explains the liquid recovery operation performed by the aid of the porous member 25. In this embodiment, the liquid immersion mechanism 1 is provided to recover only the liquid LQ via the recovery port 22. Therefore, the liquid immersion mechanism 1 is capable of satisfactorily recovering the liquid LQ without allowing any gas to flow into the space 24 via the recovery port 22.

With reference to Fig. 6, the porous member 25 is provided for the recovery port 22. The substrate P is arranged under the porous member 25. The gas space and the liquid space are formed between the porous member 25 and the substrate P. More specifically, the gas space is formed between a first hole 25Ha of the porous member 25 and the substrate P, and the liquid space is formed between a second hole 25Hb of the porous member 25 and the substrate P. The recovery flow passage (flow passage space) 24 is formed over the porous member 25.

The liquid immersion mechanism 1 of the embodiment of the present invention is set so that the following condition is satisfied:

$$(4 \times \gamma \times \cos\theta)/d \geq (Pa - Pc) \qquad \ldots(1)$$

wherein Pa represents the pressure in the space K3 between the substrate P and the first hole 25Ha of the porous member 25 (pressure on the lower surface of the porous member 25H), Pc represents the pressure in the flow passage space 24 over the porous member 25 (pressure on the upper surface of the porous member 25), d represents the pore size (diameter) of the holes 25Ha, 25Hb, $\theta$ represents the contact angle of the porous member 25 (inner side surface of the hole 25H) with respect to the liquid LQ, and $\gamma$ represents the surface tension of the liquid LQ. In the expression (1) described above, the hydrostatic pressure of the liquid LQ over the porous member 25 is not considered in order to simplify the explanation.

In this case, it is necessary that the contact angle $\theta$ between the liquid LQ and the porous member 25 (inner side surface of the pore 25H) satisfies the following condition.

$$\theta \leq 90° \qquad \ldots(2)$$

If the foregoing condition holds, even when the gas space is formed on the lower side of the first hole 25Ha of the porous member 25 (on the side of the substrate P), then the gas in the space K3 disposed on the lower side of the porous member 25 is prevented from any movement (inflow) into the flow passage space 24 disposed on the upper side of the porous member 25 via the hole 25Ha. That is, when the pore size d of the porous member 25, the contact angle (affinity) $\theta$ of the porous member 25 with respect to the liquid LQ, the surface tension $\gamma$ of the liquid LQ, and the pressures Pa, Pc are optimized so that the foregoing condition is satisfied, then the interface between the liquid LQ and the gas can be maintained at the inside of the first hole 25Ha of the porous member 25, and it is possible to suppress the inflow of the gas from the space K3 into the flow passage space 24 via the first hole 25Ha. On the other hand, the liquid space is formed on the lower side of the second hole 25Hb of the porous member 25 (on the side of the substrate P). Therefore, it is possible to recover only the liquid LQ by the aid of the second hole 25Hb.

In this embodiment, the pressure Pa of the space K3 disposed on the lower side of the porous member 25, the pore size d, the contact angle $\theta$ of the porous member 25 (inner side surface of the hole 25H) with respect to the liquid LQ, and the surface tension $\gamma$ of the liquid (pure water) LQ are substantially constant. The liquid immersion mechanism 1 adjusts the pressure Pc of the flow passage space 24 disposed on the upper side of the porous member 25 so that the foregoing condition is satisfied by controlling the suction force of the liquid recovery unit 21.

In the expression (1), the larger the absolute value of (Pa - Pc) is, i.e., the larger the absolute value of $((4 \times \gamma \times \cos\theta)/d)$ is, the more easily the pressure Pc to satisfy the foregoing condition is controlled. Therefore, it is desirable that the pore size d is miniaturized to be as small as possible, and the contact angle $\theta$ of the porous member 25 with respect to the liquid LQ is decreased to be as small as possible. In the embodiment of the present invention, the porous member 25 is liquid-attractive with respect to the liquid LQ, which has the sufficiently small contact angle $\theta$.

As described above, in the embodiment of the present invention, the difference in pressure between the space 24 over the porous member 25 and the space K3 under the porous member 25 (difference in pressure between the upper surface and the lower surface of the porous member 25) is controlled to satisfy the foregoing condition in the state in which the porous member 25 is wet. Accordingly, only the liquid LQ is recovered from the hole 25H of the porous member 25. Thus, it is possible to suppress the occurrence of the vibration which would be otherwise caused such that the liquid LQ and the gas are sucked together.

Next, an explanation will be made about a method for exposing the pattern image of the mask M onto the substrate P by using the exposure apparatus EX constructed as described above.

In order to fill the optical path space K1 for the exposure light beam EL with the liquid LQ, the control unit CONT drives the liquid supply unit 11 and the liquid recovery unit 21 respectively. The liquid LQ, which is fed from the liquid supply unit 11 under the control of the control unit CONT, is allowed to flow through the supply tube 13, and then the liquid LQ is supplied from the supply ports 12 via the supply flow passages 14 of the nozzle member 70 to the internal space G2 between the bottom plate 70D and the final optical element LS1 of the projection optical system PL. The liquid LQ, which is supplied to the internal space G2 from the supply ports 12, is allowed to flow while being spread on the upper surface 77 of the bottom plate 70D, and the liquid LQ arrives at the opening 74. When the liquid LQ is supplied to the internal space G2, the gas, which has been present in the internal space G2, is discharged to the external space K3 via the gas discharge ports 16 and/or the opening 74. Therefore, it is possible to avoid the inconvenience which would be otherwise caused such that the gas remains or stays in the internal space G2 upon the start of the supply of the liquid LQ to the internal space G2. It is possible to avoid the inconvenience which would be otherwise caused such that gas(bubble) is formed in the liquid LQ in the optical path space K1.

In this embodiment, the recesses 78 are provided in the vicinity of the gas discharge ports 16 disposed on the upper surface 77 of the bottom plate 70D. Accordingly, even when the gap is small between the lower surface T1 of the final optical element LS1 and the upper surface 77 of the bottom plate 70D, the gas in the internal space G2 can be smoothly discharged to the external space K3 via the recesses 78 and the gas discharge ports 16, because the flow passages disposed in the vicinity of the gas discharge ports 16 are widened owing to the recesses 78.

In this case, the upper end of the gas discharge flow passage 15 is connected to the atmospheric space (external space) K3 to be in the state of being open to the atmospheric air. However, the upper end of the gas discharge flow passage 15 may be connected to a suction unit such as a vacuum system to forcibly discharge the gas in the internal space G2.

Alternatively, the liquid LQ may be supplied to the internal space G2 from the ports (gas discharge ports) 16 provided on the both sides in the X axis direction with respect to the optical path space K1. Further, the gas in the internal space G2 may be discharged to the external space K3 from the ports (supply ports) 12 provided on the both sides in the Y axis direction with respect to the optical path space K1.

The internal space G2 is filled with the liquid LQ supplied to the internal space G2. After that, the liquid LQ is allowed to flow via the opening 74 into the space between the first land surface 75 and the substrate P (substrate stage PST) to fill the optical path space K1 for the exposure light beam EL therewith. The optical path space K1 for the exposure light beam EL, which is disposed between the final optical element LS1 (projection optical system PL) and the substrate P, is filled with the liquid LQ by supplying the liquid LQ from the supply ports 12 to the internal space G2 between the final optical element LS1 and the bottom plate 70D as described above.

In this situation, the liquid recovery unit 21, which is driven under the control of the control unit CONT, recovers a predetermined amount of the liquid LQ per unit time. The liquid recovery unit 21, which includes the vacuum system, can recover the liquid LQ existing between the recovery port 22 (porous member 25) and the substrate P via the recovery port 22 by providing the negative pressure in the space 24. The liquid LQ, with which the optical path space K1 for the exposure light beam EL is filled, is allowed to flow into the recovery flow passage 24 via the recovery port 22 of the nozzle member 70. The liquid LQ is allowed to flow through the recovery tube 23, and then the liquid LQ is recovered by the liquid recovery unit 21.

As described above, the control unit CONT uses the liquid immersion mechanism 1 so that the predetermined amount per unit time of the liquid LQ is supplied to the optical path space K1, and the predetermined amount per unit time of the liquid LQ is recovered from the optical path space K1. Accordingly, the liquid immersion area LR can be locally formed on the substrate P with the liquid LQ for filling the optical path space K1 for the exposure light beam EL between the projection optical system PL and the substrate P and the liquid LQ for filling the space between the nozzle member 70 and the substrate P. The control unit CONT projects the pattern image of the mask M onto the substrate P via the projection optical system PL and the liquid LQ in the optical path space K1 while relatively moving the projection optical system PL and the substrate P in the state in which the optical path space K1 for the exposure light beam EL is filled with the liquid LQ. As described above, the exposure apparatus EX of this embodiment is the scanning type exposure apparatus in which the Y axis direction is the scanning direction. Therefore, the control unit CONT controls the substrate stage PST so that the substrate P is exposed by radiating the exposure light beam EL onto the substrate P while moving the substrate P in the Y axis direction.

The following possibility arises in the scanning type exposure apparatus as described above depending on the structure of the nozzle member. That is, for example, there is a possibility that the liquid LQ is not recovered sufficiently via the recovery port 22 as the scanning velocity (movement velocity) of the substrate P is increased to be high, and the liquid LQ, with which the optical path space K1 is filled, may leak to the outside of the recovery port 22 with respect to the optical path space K1 (outside of the space disposed between the nozzle member 70 and the substrate P).

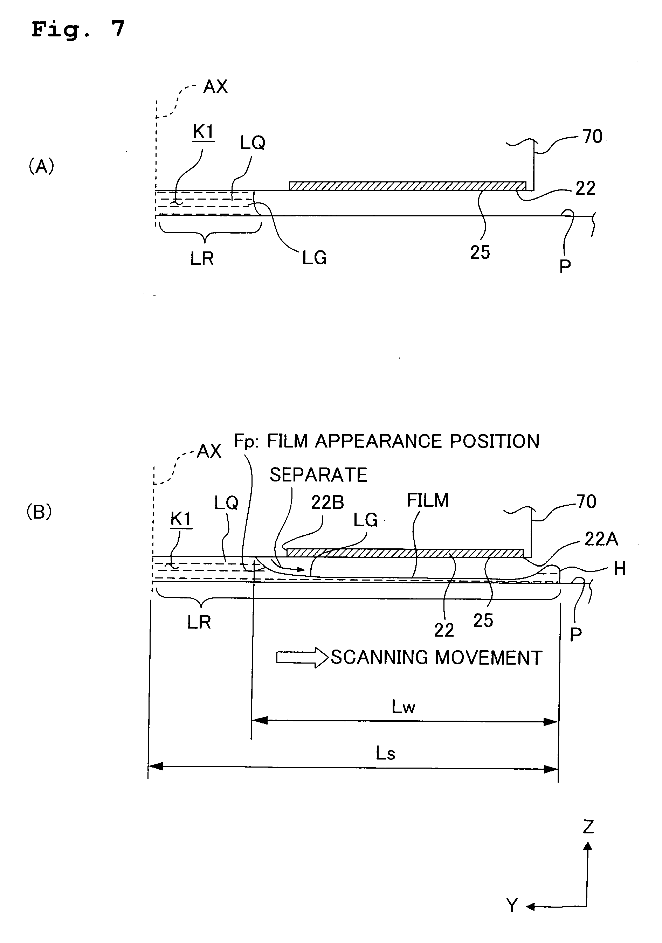

For example, when the substrate P is moved in the -Y direction at a predetermined velocity by a predetermined distance with respect to the liquid immersion area LR starting from a state as schematically shown in Fig. 7A, the interface LG, which is disposed between the liquid LQ of the liquid immersion area LR and the space located outside thereof, is moved outwardly with respect to the optical path space K1 for the exposure light beam EL in accordance with the movement of the substrate P. During the movement, the following possibility arises as schematically shown in Fig. 7B. That is, the liquid LQ, which has been in contact with the lower surface of the nozzle member 70, may be separated (exfoliated) from a part of the lower surface of the nozzle member 70, and the film (thin film) of the liquid LQ may be formed on the substrate P. In the following description, the position, at which the liquid LQ having been in contact with the lower surface of the nozzle member 70 makes separation in accordance with the movement of the substrate P (movement of the interface LG), is appropriately referred to as "film appearance position Fp".

The formed film of the liquid LQ is separated from the recovery port 22 (porous member 25). Therefore, a situation may possibly arise such that the film of the liquid LQ cannot be recovered by the recovery port 22. That is, a situation may possibly arise such that the recovery port 22 cannot recover the liquid LQ, because the formed film of the liquid LQ does not make contact with the porous member 25 arranged at the recovery port 22. In such a situation, any inconvenience may possibly arise, for example, such that the liquid LQ may leak to the outside of the recovery port 22 and/or the film of the liquid LQ may become liquid droplets to remain on the substrate P. As the movement velocity of the substrate P is increased to be high, the film of the liquid LQ may be highly possibly formed on the substrate P, and the size Lw of the film may be highly possibly increased. Therefore, as the movement velocity of the substrate P is increased to be high, there is such a high possibility that the liquid LQ cannot be recovered sufficiently via the recovery port 22. The size Lw of the film herein refers to the distance between the film appearance position Fp and the end portion H of the film of the liquid LQ on the frontward side in the movement direction of the substrate P (on the -Y side in this situation).

According to the research performed by the present inventor, it has been revealed that the liquid LQ can be recovered by means of the recovery port 22 provided that the film of the liquid LQ can be formed at the inside of the recovery port 22 with respect to the optical path space K1. The present inventor has found out the occurrence of the following phenomenon as a result of, for example, an experiment. That is, for example, as shown in Fig. 7, when the substrate P is moved in the -Y direction (in particular, when the acceleration is applied in the +Y direction to the substrate P during the movement in the -Y direction), the thickness (film thickness) in the vicinity of the end portion H of the film of the liquid LQ is thickened, for example, on account of the surface tension of the liquid LQ (see Fig. 7B). Therefore, when the end portion H of the liquid LQ is formed at the inside of the outer edge 22A of the recovery port 22 with respect to the optical path space K1, in other words, when the recovery port 22 (porous member 25) can be opposed to the end portion H of the film of the liquid LQ, then the porous member 25 of the recovery port 22 is successfully allowed to make contact with the liquid LQ (end portion H), and the liquid LQ can be recovered via the recovery port 22. Further, when the end portion H of the liquid LQ is formed at the inside of the inner edge 22B of the recovery port 22 with respect to the optical path space K1, the formed film of the liquid LQ can be recovered via the recovery port 22 together with the liquid LQ of the liquid immersion area LR by moving the substrate P in the direction (+Y direction in this situation) opposite to the direction in which the film of the liquid LQ is formed with respect to the optical path space K1.

However, as described above, there is such a high possibility that the size Lw of the film may be enormously expanded as the movement velocity of the substrate P is increased to be high. Therefore, if it is intended to recover the film of the liquid LQ via the recovery port 22, it is necessary that the recovery port 22 should be provided at any position separated far from the optical path space K1 (optical axis AX of the projection optical system PL). Therefore, an inconvenience arises such that the nozzle member 70 may be enormously large-sized, and the entire exposure apparatus EX may be consequently enormously large-sized. Further, if the film appearance position Fp is separated far from the optical path space K1 (optical axis AX), then the distance Ls between the optical path space K1 (optical axis AX) and the end portion H of the film of the liquid LQ is increased, and the liquid immersion area LR is consequently enormously expanded. Therefore, if it is intended to recover the liquid LQ via the recovery port 22, then it is necessary that the nozzle member 70 should be enormously large-sized, and the exposure apparatus EX may be consequently enormously large-sized.

Accordingly, in this embodiment, the first land surface 75 and the second land surfaces 76 (or the recesses 72 disposed adjacently to the first land surface 75: space-forming areas) are provided on the lower surface of the nozzle member 70 opposed to the substrate P so that the enormous expansion of the liquid immersion area LR and the enormous expansion of the nozzle member 70 can be suppressed, and the optical path space K1 can be satisfactorily filled with the liquid LQ even when the substrate P is moved.

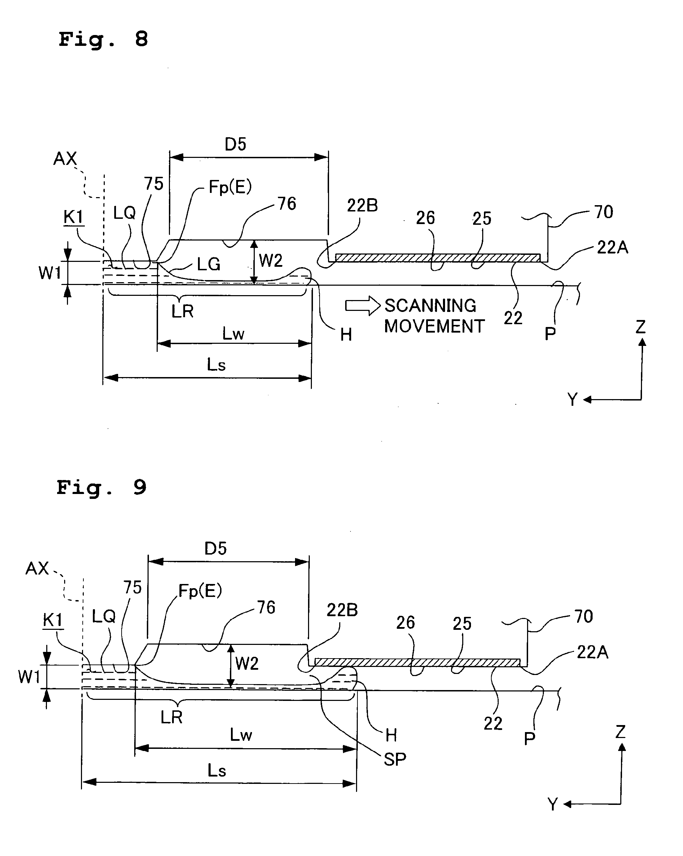

Fig. 8 schematically illustrates an example of the behavior of the liquid immersion area LR when the substrate P is moved in the -Y direction. As described above, the first land surface 75 is the flat surface which is substantially parallel to the surface of the substrate P and which is liquid-attractive. The liquid LQ, which exists between the surface of the substrate P and the first land surface 75, makes tight contact with the first land surface 75. The liquid LQ is satisfactorily retained between the surface of the substrate P and the first land surface 75.

The second land surfaces 76 are separated farther from the surface of the substrate P as compared with the first land surface 75. The difference in height is provided with respect to the second land surface 76 at the edge E of the first land surface 75. Therefore, when the interface LG of the liquid LQ retained between the surface of the substrate P and the first land surface 75 is moved to the outside of the first land surface 75 with respect to the optical path space K1 for the exposure light beam EL, the liquid LQ, which has been in contact with the first land surface 75, is separated from the second land surface 76 at the edge E of the first land surface 75. The liquid LQ, which exists between the surface of the substrate P and the second land surface 76, forms the film which is thinner than the distance (spacing distance) W1 between the surface of the substrate P and the first land surface 75. The film of the liquid LQ existing between the surface of the substrate P and the second land surface 76 does not make contact with the second land surface 76. In other words, the space SP, in which no liquid exists, is formed between the second land surface 76 and the film of the liquid LQ existing on the substrate P opposed to the second land surface 76. The space SP is provided by the recess 76 which defines or comparts the second land surface 76.

The film appearance position Fp is established at the edge E of the first land surface 75 by providing the second land surface 76 (recess 72) at the outside of the first land surface 75 with respect to the optical path space K1 as described above. In other words, the film appearance position Fp is defined by the first land surface 75 and the second land surface 76 (recess 72) in the case of the nozzle member 70 of this embodiment.

As explained, for example, with reference to Fig. 3, the width D1 of the first land surface 75 is sufficiently small in the Y axis direction (scanning direction). Therefore, it is possible to decrease the distance Ls between the optical path space K1 (optical axis AX) and the end portion H of the formed film of the liquid LQ.

In this embodiment, the position of the edge E of the first land surface 75 and the position (size) of the recovery port 22 are established so that the film of the liquid LQ, which is generated at the edge E as the boundary between the first land surface 75 and the second land surface 76, is formed at the inside of the recovery port 22 with respect to the optical path space K1 for the exposure light beam EL. In the example shown in Fig. 8, the positional relationship (distance) between the recovery port 22 and the edge E of the first land surface 75 is established so that the film of the liquid LQ (end portion H) is formed at the inside of the inner edge 22B of the recovery port 22 with respect to the optical path space K1. That is, the recess 72, which is the space-forming area, is formed between the optical path space K1 and the recovery port 22 so that the film is formed at the inside of the inner edge 22B of the recovery port 22 with respect to the optical path space K1. Accordingly, it is possible to avoid, for example, the leakage and the remaining of the liquid LQ. Further, the second land surface 76 is provided so that the liquid LQ, which is present between the surface of the substrate P and the second land surface 76, is thinner than the distance W1. The film of the liquid LQ makes no contact with the second land surface 76. When the second land surface 76 is separated farther from the surface of the substrate P as compared with the first land surface 75, it is possible to avoid, for example, the adhesion and the remaining of the liquid LQ on the second land surface 76.

As shown in Fig. 9, for example, even when the size Lw of the film is increased as the movement velocity of the substrate P is increased to be high, the position of the edge E of the first land surface 75 and the position of the recovery port 22 are established so that the film of the liquid LQ (end portion H) is formed at the inside of the outer edge 22A of the recovery port 22 with respect to the optical path space K1. That is, the recess 72, which is the space-forming area, is formed between the optical path space K1 and the recovery port 22 so that the film is formed at the inside of the inner edge 22A of the recovery port 22 with respect to the optical path space K1. Therefore, it is possible to avoid, for example, the leakage and the remaining of the liquid LQ. The distance between the lower surface 26 of the porous member 25 and the surface of the substrate P is approximately equal to the distance between the first land surface 75 and the surface of the substrate P. The porous member 25 is provided at the position capable of making contact with the liquid LQ of the end portion H which is the portion having the thick film thickness of the formed film of the liquid LQ. Therefore, as shown in Fig. 9, the liquid LQ can be recovered by setting the position of the edge E of the first land surface 75 and the position of the recovery port 22 (outer edge 22A) so that the recovery port 22 (porous member 25) is opposed to the end portion H of the film of the liquid LQ, i.e., the film (end portion H) of the liquid LQ is formed at the inside of the outer edge 22A of the recovery port 22. Owing to the presence of the second land surface 76 (recess 72), the space exists over the portion of the film of the liquid LQ having the thin thickness. That is, in this embodiment, the liquid LQ of the liquid immersion area formed on the substrate P is recovered from the recovery port 22 while the liquid LQ forms the space SP (space disposed under the space defined or comparted in the recess 72) with respect to the second land surface 76.

As described above, the size Lw of the film of the liquid LQ is changed depending on, for example, the movement velocity of the substrate P when the substrate P is exposed. Therefore, the size D5 of the second land surface 76 (or the recess 72) in the Y axis direction can be set depending on, for example, the movement velocity of the substrate P in the Y axis direction when the substrate P is exposed so that the film of the liquid LQ is formed at the inside of the recovery port 22. The maximum velocity of the substrate stage PST is previously known. Therefore, the size D5 of the second land surface 76 (or the recess 72) can be set depending on the maximum velocity. For example, when the substrate P is exposed while moving the substrate P at a high velocity, there is such a high possibility that the size Lw of the film of the liquid LQ may be increased. Therefore, the film of the liquid LQ can be formed at the inside of the recovery port 22 by increasing the size D5 of the second land surface 76, and consequently increasing the distance between the recovery port 22 and the edge E of the first land surface 75. Therefore, it is possible to avoid, for example, the leakage and the remaining of the liquid LQ. On the other hand, when the substrate P is exposed while moving the substrate P at a relatively low velocity, there is such a high possibility that the size Lw of the film of the liquid LQ may be small. Therefore, even when the size D5 of the second land surface 76 is decreased, and the distance between the recovery port 22 and the edge E of the first land surface 75 is consequently decreased, then the film of the liquid LQ can be formed at the inside of the recovery port 22. Therefore, it is possible to miniaturize the nozzle member 70, and it is possible to consequently miniaturize the entire exposure apparatus EX.

The size Lw of the film of the liquid LQ may be possibly changed depending on, for example, the acceleration, the distance of movement, and the direction of movement (locus of movement) when the substrate P is moved as well, without being limited to the movement velocity. Therefore, the position of the edge E of the first land surface 75 and the size of the second land surface 76 (recess 72) can be set depending on the movement condition including at least one of the movement velocity, the acceleration, the distance of movement, and the direction of movement (locus of movement) of the substrate P as described above.

The size Lw of the film of the liquid LQ may be possibly changed depending on the contact angle between the substrate P and the liquid LQ as well. For example, when the contact angle between the substrate P and the liquid LQ is small, in other words, when the surface of the substrate P is liquid-attractive, then there is such a high possibility that the size Lw of the film of the liquid LQ formed on the substrate P may be increased when the substrate P is exposed while moving the substrate P. Therefore, in such a situation, the film of the liquid LQ can be formed at the inside of the recovery port 22 by increasing the size D5 of the second land surface 76 (or the recess 72) and consequently increasing the distance between the recovery port 22 and the edge E of the first land surface 75. On the other hand, when the contact angle between the substrate P and the liquid LQ is large, in other words, when the surface of the substrate P is liquid-repellent, then there is such a high possibility that the size Lw of the film of the liquid LQ to be formed may be small when the substrate P is exposed while moving the substrate P. Therefore, in such a situation, the film of the liquid LQ can be formed at the inside of the recovery port 22 even when the size D5 of the second land surface 76 (or the recess 72) and consequently the distance between the recovery port 22 and the edge E of the first land surface 75 are decreased. Therefore, it is possible to miniaturize the nozzle member 70, and it is possible to consequently miniaturize the entire exposure apparatus EX. As described above, the position of the edge E of the first land surface 75 and the size D5 of the second land surface 76 in the Y axis direction can be set depending on the contact angle between the substrate P and the liquid LQ.

Further, there is such a possibility that the size Lw of the film of the liquid LQ may be changed depending on the liquid immersion condition adopted when the liquid immersion area LR is formed as well. The liquid immersion condition herein includes at least one of the supply condition of the liquid LQ to be supplied to the optical path space K1 and the recovery condition of the liquid LQ to be recovered from the optical path space K1. The supply condition of the liquid LQ includes, for example, the liquid supply amount per unit time, the supply position of the liquid LQ with respect to the optical path space K1, and the supply direction. The recovery condition of the liquid LQ includes, for example, the liquid recovery amount per unit time, the recovery position of the liquid LQ with respect to the optical path space K1, and the recovery direction. There is also such a possibility that the size Lw of the film of the liquid LQ to be formed may be changed depending on the difference in the liquid immersion condition as described above. Therefore, the position of the edge E of the first land surface 75 and the size of the second land surface 76 (recess 72) may be set depending on the liquid immersion condition.

As explained above, the second land surface 76 (recess 72) is provided so that the film of the liquid LQ, which exists between the surface of the substrate P and the second land surface 76 (recess 72), does not make contact with the second land surface 76. Therefore, even when the substrate P is exposed while moving the substrate P, it is possible to avoid the inconvenience including, for example, the leakage and the remaining of the liquid LQ. The liquid LQ can be retained satisfactorily by means of the first land surface 75. The optical path space K1 for the exposure light beam EL can be filled with the liquid LQ in the desired state.

The film appearance position Fp is successfully allowed to approach the optical path space K1 (optical axis AX) by sufficiently decreasing the size of the first land surface 75. Therefore, it is possible to realize, for example, the miniaturization of the liquid immersion area LR and the miniaturization of the nozzle member 70. Therefore, it is desirable that the width D1 of the first land surface 75 in the Y axis direction is made to be as small as possible within the range in which the phenomenon (for example, the liquid cutoff phenomenon in which the liquid LQ of the optical path space K1 is cut off or discontinuous) is not caused, which would be otherwise caused such that any bubble is formed in the optical path space K1 and/or gas is formed, for example, when the substrate P is moved in the +Y direction after the substrate P is subjected to the liquid immersion exposure while moving the substrate P in the -Y direction. In other words, it is desirable that the first land surface 75 is made to be as small as possible within the range in which the liquid LQ can be satisfactorily retained between the first land surface 75 and the substrate P even when the substrate P is moved in the +Y direction after the substrate P is subjected to the liquid immersion exposure while moving the substrate P in the -Y direction. Similarly, it is desirable that the width D3 of the first land surface 75 in the X axis direction is made to be as small as possible within the range in which the inconvenience is not caused, which would be otherwise caused, for example, such that any bubble is formed in the optical path space K1 even when the substrate P is subjected to the stepping movement in the X axis direction.

In this embodiment, the first land surface 75 is rectangular, in which the X axis direction is the longitudinal direction. The width D1 of the first land surface 75 in the Y axis direction is provided to be sufficiently smaller than the width D3 in the X axis direction and the width D2 of the opening 74. The optical path space K1 can be satisfactorily filled with the liquid LQ while suppressing the enormous expansion of the liquid immersion area LR.

The second land surfaces 76 are provided on the both sides of the first land surface 75 in the Y axis direction respectively. Therefore, when the substrate P is exposed while moving the substrate P in relation to the Y axis direction, it is possible to make the response to the movement in the +Y direction and the movement in the -Y direction respectively.

In this embodiment, the second land surface 76 is the flat surface which is substantially parallel to the surface of the substrate P held by the substrate stage PST. However, it is also allowable that the second land surface 76 is not parallel to the surface of the substrate P held by the substrate stage PST, and the second land surface 76 is not the flat surface. The surface state of the second land surface 76, which includes, for example, the concave/convex shape and the angle with respect to the substrate P, may be arbitrarily designed on condition that the film of the liquid LQ, which exists between the surface of the substrate P and the second land surface 76, does not make contact with the second land surface 76.

In this embodiment, the second land surface 76 is provided to form the recess 72 with respect to the first land surface 75. However, the inclination and/or the shape of the first land surface 75 may be changed to form the space between the liquid on the substrate P and the lower surface of the nozzle member 70 provided that the liquid LQ can be satisfactorily retained with respect to the substrate P. For example, the first land surface 75 may be inclined continuously or in a stepwise manner so that the first land surface 75 gradually approach the substrate P in the direction directed toward the recovery port 22. Accordingly, the height (position in the Z direction) of the outer edge E of the first land surface 75 is lower than the height of the inner edge (edge disposed on the side of the optical path space K1). The height of the second land surface 76 is higher than the height of the outer edge E of the first land surface 75. Therefore, even when the second land surface 76 has the same height as that of the inner edge of the first land surface 75, the space SP can be formed over the liquid LQ at the outside of the edge E (between the second land surface 76 and the substrate P) when the liquid LQ is moved to the outside of the first land surface 75 with respect to the optical path space K1 in accordance with the movement of the substrate P.

Alternatively, a projection, which protrudes toward the substrate P, may be provided between the first land surface 75 and the second land surface, while the first land surface 75 and the second land surface have the same height. When the liquid LQ is moved to the outside of the first land surface 75 with respect to the optical path space K1 in accordance with the movement of the substrate P, the projection functions such that the space SP can be formed over the liquid LQ between the second land surface 76 and the substrate P immediately after the liquid LQ passes over the projection. That is, the lower surface of the nozzle member 70 can be provided with the area (space-forming area) having any shape or structure to generate the space SP between the lower surface of the nozzle member 70 and the liquid LQ existing between the substrate P and the lower surface of the nozzle member 70 in the range from the optical path space K1 to the recovery port 22 (especially in the Y direction) when the liquid LQ is moved to the outside of the first land surface 75 with respect to the optical path space K1 in accordance with the movement of the substrate P. However, it goes without saying that the space-forming area has such a structure and shape that the liquid LQ in the optical path space K1 is maintained to be in a desired state, for example, any gas (including the bubble) is not generated in the liquid in the optical path space K1.

In this embodiment, the liquid-repelling treatment is performed to the second land surface 76. However, even when the liquid-repelling treatment is not performed to the second land surface 76, the liquid LQ, which exists between the surface of the substrate P and the second land surface 76, is successfully allowed to make no contact with the second land surface 76 by providing the second land surface 76 at the position away farther from the surface of the substrate P as compared with the first land surface 75. Therefore, it is not necessarily indispensable that the second land surface 76 has the liquid repellence. For example, the "GOLDEP" treatment or the "GOLDEP WHITE" treatment described above makes it possible to suppress the elution of any impurity from the nozzle member 70 to the liquid LQ. Therefore, it is possible to perform the "GOLDEP" treatment or the "GOLDEP WHITE" treatment to any predetermined position of the nozzle member 70 including the second land surface 76.

The liquid-attracting treatment, which is to be performed to the first land surface 75, may be omitted provided that the liquid LQ can be retained with respect to the substrate P. That is, it is also allowable that the first land surface 75 is not liquid-attractive.

Second Embodiment

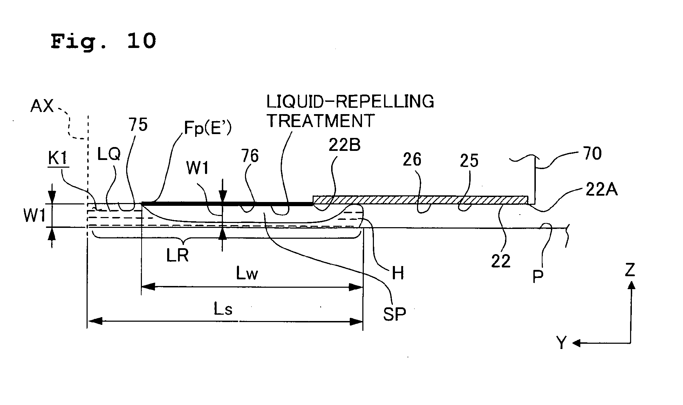

Next, a second embodiment will be explained with reference to Fig. 10. In the following description, the constitutive components, which are the same as or equivalent to those of the embodiment described above, will be simplified or omitted from the explanation.

In the first embodiment described above, the second land surfaces 76 are provided at the positions away farther from the surface of the substrate P as compared with the first land surface 75 so that the film of the liquid LQ, which exists between the surface of the substrate P and the second land surface 76, does not make contact with the second land surface 76. However, when the second land surface 76 is made to be liquid-repellent, the film of the liquid LQ, which exists between the surface of the substrate P and the second land surface 76, does not make contact with the second land surface 76, even when the second land surface 76 is not provided at the position away farther from the surface of the substrate P as compared with the first land surface 75. That is, in this embodiment, as shown in Fig. 10, even when the position (height) of the first land surface 75 with respect to the surface of the substrate P is approximately the same as the position (height) of the second land surface 76, the film of the liquid LQ, which exists between the surface of the substrate P and the second land surface 76, is successfully allowed to make no contact with the second land surface 76 by allowing the second land surface 76 to be liquid-repellent. For example, when the contact angle of the liquid LQ on the second land surface 76 is not less than 100°, the liquid LQ, which exists between the surface of the substrate P and the second land surface 76, can be exfoliated from the second land surface 76. That is, in this embodiment, the second land surface 76, which has the liquid repellence, is the space-forming area. The space SP is formed between the liquid LQ and the second land surface 76 on the substrate P disposed under the second land surface 76 by the space-forming area.

With reference to Fig. 10, the first land surface 75 and the second land surface 76 are provided to be substantially flush with each other. The liquid-repelling treatment is performed to the second land surface 76 to provide the liquid repellence with respect to the liquid LQ. The liquid-repelling treatment includes, for example, treatments for applying or adhering any liquid-repellent material including, for example, a fluorine-based resin material such as polytetrafluoroethylene (Teflon, trade name), an acrylic resin material, and a silicon-based resin material.

When the second land surface 76 is allowed to have the liquid repellence, the film of the liquid LQ, which exists between the surface of the substrate P and the second land surface 76, can be prevented from making any contact with the second land surface 76 in the same manner as in the first embodiment. The liquid LQ, which exists between the surface of the substrate P and the second land surface 76, can be made thinner than the distance W1 between the surface of the substrate P and the first land surface 75. When the interface LG of the liquid LQ between the surface of the substrate P and the first land surface 75 is moved toward the outside of the first land surface 75 with respect to the optical path space K1 for the exposure light beam EL, the liquid LQ, which has been in contact with the first land surface 75, can be separated from the second land surface 76. Also in this case, for example, the positional relationship between the edge E' of the first land surface 75 and the recovery port 22 and the size of the recovery port 22 are set so that the film of the liquid LQ, which appears at the boundary E' between the first land surface 75 and the second land surface 76, is formed at the inside of the outer edge of the recovery port 22 with respect to the optical path space K1 for the exposure light beam EL. The size of the second land surface 76 in the Y axis direction is set depending on, for example, the movement velocity of the substrate P and the contact angle between the substrate P and the liquid LQ in the same manner as in the first embodiment so that the film of the liquid LQ is formed at the inside of the outer edge of the recovery port 22 with respect to the optical path space K1 for the exposure light beam EL. In the first and second embodiments described above, the heights (positions in the Z direction) may be different from each other between the first land surface 75 and the lower surface 26 of the porous member 25. That is, it is enough that the lower surface 26 of the porous member 25 is arranged to have the height (position in the Z direction) so that the end portion H of the thin film of the liquid LQ formed on the substrate P makes contact therewith.

Third Embodiment

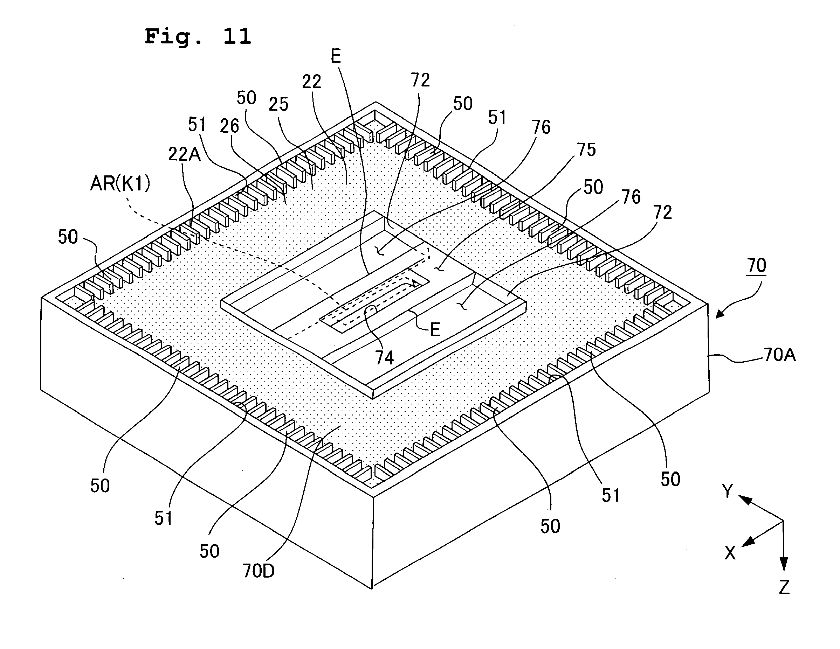

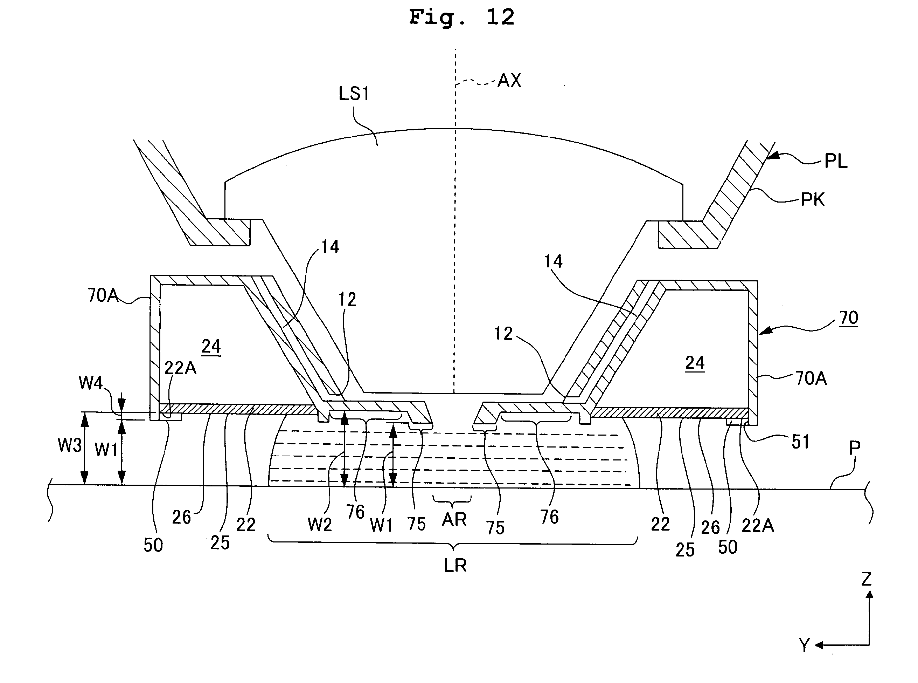

Next, a third embodiment will be explained with reference to Figs. 11 and 12. As shown in Figs. 11 and 12, fin members 50 are provided at the recovery port 22. The fin members 50 are provided on the lower surface 26 of the porous member 25 of the recovery port 22. The fin members 50 are provided in the vicinity of the outer edge 22A of the recovery port 22 on the lower surface 26 of the porous member 25. A plurality of the fin members 50 are provided radially with respect to the optical path space K1.

In this embodiment, the distance W3 between the surface of the substrate P and the lower surface 26 of the porous member 25 arranged at the recovery port 22 is larger than the distance W1 between the surface of the substrate P and the first land surface 75. In this embodiment, the distance W1 is about 1 mm, and the distance W3 is about 1.5 mm. The position (height) of the first land surface 75 with respect to the surface of the substrate P is provided to be approximately same as the position (height) of the lower end of the side plate 70A of the nozzle member 70 with respect to the surface of the substrate P. That is, the distance between the lower end of the side plate 70A and the surface of the substrate P is about 1 mm. The portion, which is disposed in the vicinity of the lower end of the side plate 70A, protrudes downwardly as compared with the lower surface 26 of the porous member 25 arranged at the recovery port 22. The wall 51, which avoid the leakage of the liquid LQ, is formed by the inner side surface of the side plate 70A which is directed toward the optical path space K1 and which protrudes downwardly as compared with the lower surface 26 of the porous member 25. Therefore, the size W4 of the wall 51 in the Z axis direction is about 0.5 mm. The wall 51 is provided at the circumferential edge (outer edge 22A) of the recovery port 22, which prevents any leakage of the liquid LQ with which the optical path space K1 is filled. The plurality of fin members 50 are provided along the wall 51.

The distance between the lower end of the fin member 50 and the surface of the substrate P is about 1 mm. That is, the size of the fin member 50 in the Z axis direction has approximately same value as that of the size W4 of the wall 51 in the Z axis direction. The distance between the lower end of the fin member 50 and the surface of the substrate P has approximately same value as that of the distance W1 between the first land surface 75 and the surface of the substrate P.

As described above, the end portion H of the film of the liquid LQ is successfully allowed to make contact with the fin members 50 provided in the recovery port 22. The liquid LQ can be satisfactorily recovered via the recovery port 22. Further, the wall 51 makes it possible to avoid the leakage of the liquid LQ to the outside of the recovery port 22.

The height of the lower end of the fin member 50 may be different from the height of the first land surface 75 on condition that the end portion H of the thin film of the liquid LQ is successfully allowed to make contact with the fin member 50. This embodiment is constructed such that the fin members 50 are provided at the circumferential edge of the recovery port 22 (porous member 25) which is provided in the annular form. However, for example, the fin members 50 may be provided at predetermined intervals in all of the area of the lower surface 26 of the porous member 25. Alternatively, the fin members 50 may be provided in only respective predetermined areas disposed on the both sides in the Y axis direction with respect to the optical path space K1 on the lower surface 26 of the porous member 25.

In the first to third embodiments described above, the second land surfaces 76 are provided on the both sides in the Y axis direction with respect to the first land surface 75 respectively. However, the second land surfaces 76 may be provided on the both sides in the X axis direction respectively.

In the first to third embodiments described above, the outer shape of the first land surface 75 is the rectangular shape in which the X axis direction is the longitudinal direction. However, it is also allowable to adopt any shape including, for example, circular shapes provided that the liquid LQ can be satisfactorily retained with respect to the substrate P, and the distance Ls between the optical path space K1 (optical axis AX) and the end portion H of the film of the liquid LQ can be decreased.

In the first to third embodiments described above, the second land surfaces 76 (space-forming areas) may be separated from the recovery port 22. For example, a buffer space, into which the liquid LQ disposed between the nozzle member 70 and the substrate P can freely inflow and from which the liquid LQ can freely outflow, may be formed at the outside of the second land surface 76 at the inside of the recovery port 22 with respect to the optical path space K1 on the lower surface of the nozzle member 70. An opening, which is formed in an annular form to surround the optical path for the exposure light beam EL in the vicinity of the inner edge 22B of the recovery port 22, is formed at the lower end of the buffer space. An upper end thereof is connected to the external space (atmospheric space). When the buffer space is provided in the vicinity of the inner edge 22B of the recovery port 22, then a part of the liquid LQ, which is allowed to flow toward the outside of the optical path space K1, is allowed to flow into the buffer space, and it is possible to decrease the amount of the liquid LQ which arrives at the recovery port 22. Therefore, it is possible to suppress the leakage of the liquid LQ more reliably. The lower end opening of the buffer space may be arranged in the vicinity of the outer edge 22A of the recovery port 22. In this case, the liquid LQ, which is included in the liquid LQ allowed to flow toward the outside of the optical path space K1 and which is not recovered by the recovery port 22, is allowed to flow into the buffer space. Therefore, it is possible to suppress the leakage of the liquid LQ. Of course, annular openings may be formed at both portions disposed in the vicinity of the outer edge 22A and in the vicinity of the inner edge 22B of the recovery port 22. Buffer spaces, into which the liquid LQ is freely allowed to inflow and from which the liquid LQ is freely allowed to outflow, may be formed for the respective openings. In this case, the member, which possesses the second land surface 76 (space-forming area), may be separated from the member which possesses the recovery port 22.

In the first to third embodiments described above, the size D5 of the second land surface 76 in the Y axis direction is set depending on, for example, the movement velocity of the substrate P and the contact angle between the substrate P and the liquid LQ. However, at least one of the movement condition of the substrate P (for example, the movement velocity, the acceleration, the direction of movement, and the distance of movement) and the liquid immersion condition (for example, the liquid supply amount and the recovery amount) may be determined depending on the size D5 of the second land surface 76. Further, the film condition (for example, the contact angle) of the surface of the substrate P capable of being exposed by the exposure apparatus EX may be determined depending on the size D5 of the second land surface 76.

The liquid immersion mechanism 1, which includes, for example, the nozzle member 70 used in the embodiment described above, is not limited to the structure described above. For example, it is also possible to use those described in European Patent Publication No. 1420298 and International Publication Nos. 2004/055803, 2004/057589, 2004/057590, and 2005/029559. In the embodiment described above, a part of the nozzle member 70 (bottom plate 70D) is arranged between the projection optical system PL and the substrate P. However, it is also allowable that a part of the nozzle member 70 is not arranged between the projection optical system PL and the substrate P. That is, the entire lower surface T1 of the final optical element LS1 of the projection optical system PL may be opposed to the substrate P. In this case, the lower surface T1 of the final optical element LS1 may be substantially flush with the lower surface of the nozzle member 70. In the embodiment described above, the supply port 12 is connected to the internal space G2. However, the supply port may be provided on the lower surface of the nozzle member 70. In the respective embodiments described above, the optical path space K1 for the exposure light beam EL is filled with the liquid LQ in the state in which the substrate P is arranged at the position capable of being irradiated with the exposure light beam EL. However, the optical path space K1 for the exposure light beam EL may be filled with the liquid LQ, for example, in a state in which any object, which is distinct from the upper surface 94 of the substrate stage PST or the substrate stage PST, is arranged at the position capable of being irradiated with the exposure light beam EL.

As described above, pure water is used as the liquid LQ in the embodiment of the present invention. Pure water is advantageous in that pure water is available in a large amount with ease, for example, in the semiconductor production factory, and pure water exerts no harmful influence, for example, on the optical element (lens) and the photoresist on the substrate P. Further, pure water exerts no harmful influence on the environment, and the content of impurity is extremely low. Therefore, it is also expected to obtain the function to wash the surface of the substrate P and the surface of the optical element provided at the end surface of the projection optical system PL. When the purity of pure water supplied from the factory or the like is low, it is also allowable that the exposure apparatus is provided with an ultra pure water-producing unit.

It is approved that the refractive index n of pure water (water) with respect to the exposure light beam EL having a wavelength of about 193 nm is approximately 1.44. When the ArF excimer laser beam (wavelength: 193 nm) is used as the light source of the exposure light beam EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In the embodiment of the present invention, the optical element LS1 is attached to the end portion of the projection optical system PL. Such a lens makes it possible to adjust the optical characteristics of the projection optical system PL, for example, the aberration (for example, spherical aberration and coma aberration). The optical element, which is attached to the end portion of the projection optical system PL, may be an optical plate which is usable to adjust the optical characteristics of the projection optical system PL. Alternatively, the optical element may be a plane-parallel through which the exposure light beam EL is transmissive.

When the pressure, which is generated by the flow of the liquid LQ, is large between the substrate P and the optical element disposed at the end portion of the projection optical system PL, it is also allowable that the optical element is tightly fixed so that the optical element is not moved by the pressure, without allowing the optical element to be exchangeable.

In the embodiment of the present invention, the space between the projection optical system PL and the surface of the substrate P is filled with the liquid LQ. However, for example, it is also allowable that the space is filled with the liquid LQ in such a state that a cover glass composed of a plane-parallel is attached to the surface of the substrate P.

In the case of the projection optical system according to the embodiment described above, the optical path space, which is disposed on the image plane side of the optical element arranged at the end portion, is filled with the liquid. However, it is also possible to adopt such a projection optical system that the optical path space, which is disposed on the side of the mask in relation to the optical element arranged at the end portion, is also filled with the liquid, as disclosed in International Publication No. 2004/019128.

The liquid LQ is water in the embodiment of the present invention. However, the liquid LQ may be any liquid other than water. For example, when the light source of the exposure light beam EL is the $F_2$ laser, the $F_2$ laser beam is not transmitted through water. Therefore, those preferably usable as the liquid LQ may include, for example, fluorine-based fluids such as fluorine-based oil and perfluoropolyether (PFPE) through which the $F_2$ laser beam is transmissive. In this case, the portion, which makes contact with the liquid LQ, is subjected to a liquid-attracting treatment by forming, for example, a thin film with a substance having a molecular structure containing fluorine having small polarity. Alternatively, other than the above, it is also possible to use, as the liquid LQ, those (for example, cedar oil) which have the transmittance with respect to the exposure light beam EL, which have the refractive index as high as possible, and which are stable against the photoresist coated on the surface of the substrate P and the projection optical system PL.

Those having refractive indexes of about 1.6 to 1.8 may be used as the liquid LQ. Further, the optical element LS1 may be formed of a material having a refractive index (for example, not less than 1.6) higher than those of silica glass and calcium fluoride. It is also possible to use, as the liquid LQ, various liquids including, for example, supercritical liquids.

The substrate P, which is usable in the respective embodiments described above, is not limited to the semiconductor wafer for producing the semiconductor device. Those applicable include, for example, the glass substrate for the display device, the ceramic wafer for the thin film magnetic head, and the master plate (synthetic silica glass, silicon wafer) for the mask or the reticle to be used for the exposure apparatus.

As for the exposure apparatus EX, the present invention is applicable not only to the scanning type exposure apparatus (scanning stepper) based on the step-and-scan manner for performing the scanning exposure with the pattern of the mask M by synchronously moving the mask M and the substrate P but also the projection exposure apparatus (stepper) based on the step-and-repeat manner for performing the full field exposure with the pattern of the mask M in a state in which the mask M and the substrate P are allowed to stand still, while successively step-moving the substrate P.

As for the exposure apparatus EX, the present invention is also applicable to the exposure apparatus based on a manner in which the full field exposure is performed on the substrate P by using a projection optical system (for example, the dioptric type projection optical system having a reduction magnification of 1/8 and including no catoptric element) with a reduction image of a first pattern in a state in which the first pattern and the substrate P are allowed to substantially stand still. In this case, the present invention is also applicable to the full field exposure apparatus based on the stitch manner in which the full field exposure is further performed thereafter on the substrate P by partially overlaying a reduction image of a second pattern with respect to the first pattern by using the projection optical system in a state in which the second pattern and the substrate P are allowed to substantially stand still. As for the exposure apparatus based on the stitch manner, the present invention is also applicable to the exposure apparatus based on the step-and-stitch manner in which at least two patterns are partially overlaid and transferred on the substrate P, and the substrate P is successively moved. The embodiments described above have been explained as exemplified by the exposure apparatus provided with the projection optical system PL by way of example. The present invention is applicable to the exposure apparatus and the exposure method in which the projection optical system PL is not used. Even when the projection optical system PL is not used as described above, then the exposure light beam is radiated onto the substrate via an optical member such as a lens, and the liquid immersion area is formed in a predetermined space between such an optical member and the substrate. The present invention is also applicable to the exposure apparatus in which a line-and-space pattern is formed on the substrate P by forming interference fringes on the substrate P as disclosed in International Publication No. 2001/035168.

The present invention is also applicable to the twin-stage type exposure apparatus. The structure and the exposure operation of the twin-stage type exposure apparatus are disclosed, for example, in Japanese Patent Application Laid-open Nos. 10-163099 and 10-214783 (corresponding to United States Patent Nos. 6,341,007, 6,400,441, 6,549,269, and 6,590,634), Japanese Patent Application Laid-open No. 2000-505958 (PCT) (corresponding to United States Patent No. 5,969,441), and United States Patent No. 6,208,407. The disclosures of them are incorporated herein by reference within a range of permission of the domestic laws and ordinances of the state designated or selected in this international application.

The present invention is also applicable to the exposure apparatus including the substrate stage which holds the substrate P and the measuring stage which carries various photoelectric sensors and/or fiducial members formed with fiducial marks, as disclosed, for example, in Japanese Patent Application Laid-open Nos. 11-135400 and 2000-164504.

In the embodiments described above, the light-transmissive type mask is used, in which the predetermined light-shielding pattern (or phase pattern or dimming or light-reducing pattern) is formed on the light-transmissive substrate. However, in place of such a mask, as disclosed, for example, in United States Patent No. 6,778,257, it is also allowable to use an electronic mask on which a transmissive pattern, a reflective pattern, or a light-emitting pattern is formed on the basis of the electronic data of the pattern to be transferred.

The present invention is also applicable to the exposure apparatus (lithography system) in which a line-and-space pattern is exposed onto the substrate P by forming interference fringes on the substrate P as disclosed in International Publication No. 2001/035168.

As described above, the exposure apparatus EX according to the embodiment of the present invention is produced by assembling the various subsystems including the respective constitutive elements as defined in claims so that the predetermined mechanical accuracy, the electric accuracy, and the optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which, for example, the temperature and the cleanness are managed.

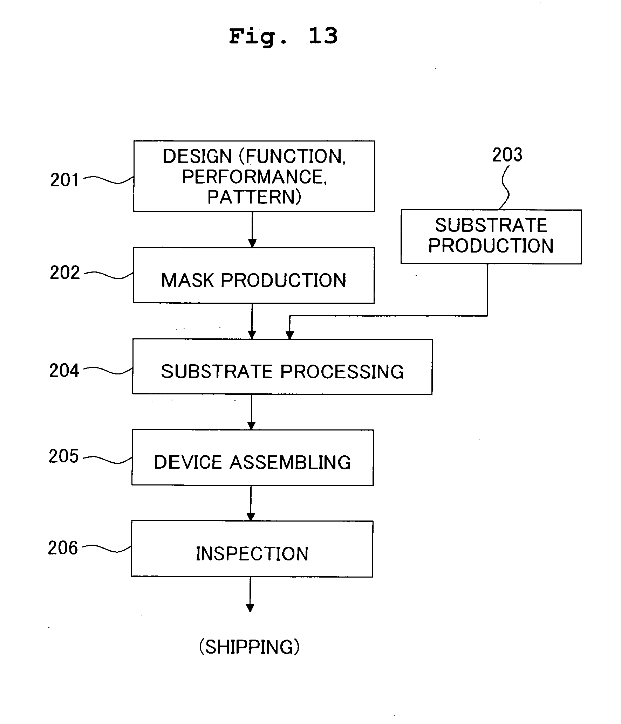

As shown in Fig. 13, the microdevice such as the semiconductor device is produced by performing, for example, a step 201 for designing the function and the performance of the microdevice, a step 202 for manufacturing a mask (reticle) based on the designing step, a step 203 for producing a substrate as a base material for the device, a substrate-processing (exposure process) step 204 for exposing a pattern of the mask onto the substrate by using the exposure apparatus EX of the embodiment described above and developing the exposed substrate, a step for assembling the device (including processing processes such as a dicing step, a bonding step, and a packaging step) 205, and an inspection step 206.

INDUSTRIAL APPLICABILITY

As for the type of the exposure apparatus EX, the present invention is not limited to the exposure apparatus for the semiconductor device production for exposing the semiconductor device pattern onto the substrate P. The present invention is also widely applicable, for example, to the exposure apparatus for producing the liquid crystal display device or for producing the display as well as the exposure apparatus for producing, for example, the thin film magnetic head, the image pickup device (CCD), the reticle, or the mask.

**Claims**

1. An exposure apparatus which exposes a substrate by radiating an exposure light beam onto the substrate, the exposure apparatus comprising:

   a liquid supply unit which supplies a liquid to fill an optical path space for the exposure light beam with the liquid; a first surface which is provided to surround the optical path space for the exposure light beam, which is arranged opposite to a surface of an object arranged at a position capable of being irradiated with the exposure light beam, and between which and the object the liquid supplied from the liquid supply unit can be retained; and a second surface which is provided outside the first surface with respect to the optical path space for the exposure light beam, and which is arranged opposite to the surface of the object, wherein:

   the second surface is provided to prevent a film of the liquid, which exists between the surface of the object and the second surface, from making contact with the second surface.

2. The exposure apparatus according to claim 1, wherein:

   the first surface is arranged while being away from the surface of the object by a first spacing distance; and the second surface is provided so that the liquid, which exists between the surface of the object and the second surface, forms the film to be thinner than the first spacing distance.

3. The exposure apparatus according to claim 1, wherein the second surface is provided so that the liquid, which has been in contact with the first surface, is separated from the second surface when an interface of the liquid between the surface of the object and the first surface is moved toward outside of the first surface with respect to the optical path space for the exposure light beam.

4. The exposure apparatus according to claim 1, wherein:

   the first surface is provided substantially in parallel to the surface of the object; and the second surface is away farther from the surface of the object as compared with the first surface.

5. The exposure apparatus according to claim 1, wherein:

   the first surface is provided substantially in parallel to the surface of the object, and the first surface is liquid-attractive with respect to the liquid; and the second surface is liquid-repellent with respect to the liquid.

6. The exposure apparatus according to claim 1, wherein:

   the exposure light beam is radiated onto the substrate while moving the substrate in a predetermined direction; and the second surface is provided on each side of the first surface in the predetermined direction.

7. The exposure apparatus according to claim 6, wherein an outer shape of the first surface is a rectangular shape in which a direction intersecting the predetermined direction is a longitudinal direction.

8. The exposure apparatus according to claim 6, wherein a size of the second surface in the predetermined direction is set depending on a movement velocity of the substrate when the substrate is exposed.

9. The exposure apparatus according to claim 6, wherein a size of the second surface in the predetermined direction is set depending on a contact angle between the substrate and the liquid.

10. The exposure apparatus according to claim 1, further comprising a recovery port which recovers the liquid and which is disposed outside the second surface with respect to the optical path space.

11. The exposure apparatus according to claim 10, wherein the recovery port is provided at a position opposite to the object.

12. The exposure apparatus according to claim 10, wherein the recovery port is provided to surround the first surface and the second surface.

13. The exposure apparatus according to claim 10, wherein a position of an edge of the first surface and a position of the recovery port are set so that the film of the liquid, which is generated at a boundary between the first surface and the second surface, is formed inside the recovery port with respect to the optical path space for the exposure light beam.

14. The exposure apparatus according to claim 10, further comprising a predetermined member which is provided at the recovery port and which makes contact with the liquid.

15. The exposure apparatus according to claim 14, wherein the predetermined member includes a porous member.

16. The exposure apparatus according to claim 15, wherein a distance between the porous member and the object is substantially equal to a distance between the first surface and the surface of the object.

17. The exposure apparatus according to claim 14, wherein the predetermined member includes a fin-shaped member.

18. The exposure apparatus according to claim 10, further comprising a wall portion which is provided at a circumferential edge portion of the recovery port and which prevents a leakage of the liquid.

19. The exposure apparatus according to claim 1, further comprising:

an optical member through which the exposure light beam passes;
a third surface which is provided to surround the optical path space for the exposure light beam and which is arranged opposite to the optical member via a predetermined gap between the optical member and the third surface; and
a supply port which is provided in the vicinity of a predetermined space disposed between the optical member and the third surface and to which the liquid is supplied from the liquid supply unit.

20. The exposure apparatus according to claim 19, further comprising a gas discharge port which is provided in the vicinity of the predetermined space and which communicates the predetermined space and external space.

21. The exposure apparatus according to claim 1, further comprising:

an optical member through which the exposure light beam passes;
a third surface which is provided to surround the optical path space for the exposure light beam and which is arranged opposite to the optical member via a predetermined gap between the optical member and the third surface; and
a gas discharge port which is provided in the vicinity of a predetermined space disposed between the optical member and the third surface and which communicates the predetermined space and external space.

22. The exposure apparatus according to claim 1, wherein the object includes the substrate.

23. A method for producing a device, comprising:

exposing a substrate by using the exposure apparatus as defined in any one of claims 1 to 22; developing the exposed substrate; and processing the developed substrate.

24. An exposure apparatus which exposes a substrate by radiating an exposure light beam onto the substrate through a liquid, the exposure apparatus comprising:

a member which is opposite to a surface of an object arranged at a position capable of being irradiated with the exposure light beam, and between which and the object the liquid can be retained; and
a recovery section which recovers the liquid retained between the object and the member,

wherein a space-forming area, which is positioned to be opposite to the surface of the object and is positioned between an optical path and the recovery section, and which provides a space between the member and the liquid on the object, is formed at the member.

25. The exposure apparatus according to claim 24, wherein the space-forming area is a recess formed on the member.

26. The exposure apparatus according to claim 24, wherein the space-forming area is a liquid-repellent area formed on a surface of the member.

27. The exposure apparatus according to claim 26, wherein a liquid-attractive area is provided between the optical path and the liquid-repellent area of the member.

28. The exposure apparatus according to claim 24, wherein the recovery section is provided at the member.

29. The exposure apparatus according to claim 24, wherein the substrate is moved in a predetermined direction when the exposure light beam is radiated onto the substrate through the liquid, and the space-forming area is provided between the optical path and the recovery section in the predetermined direction.

30. A method for producing a device, comprising:

exposing a substrate by using the exposure apparatus as defined in any one of claims 24 to 29; developing the exposed substrate; and processing the developed substrate.

31. An exposure method for exposing a substrate by radiating an exposure light beam onto the substrate through a liquid, the exposure method comprising:

supplying the liquid to a space between the substrate and a member arranged to be opposite to the substrate;
recovering the liquid while providing a space between the member and the liquid on the substrate; and
exposing the substrate by radiating the exposure light beam onto the substrate through the liquid.

32. The exposure method according to claim 31, further comprising moving the substrate in a predetermined direction when the exposure light beam is radiated onto the substrate through the liquid, wherein the liquid is recovered while the space is provided between the liquid and the member in the predetermined direction.

33. The exposure method according to claim 31, further comprising:

moving the substrate in a predetermined direction,

wherein:

the liquid is recovered by the liquid recovery section while providing the space between an optical path space for the exposure light beam in the predetermined direction and the liquid recovery section arranged to be opposite to the substrate.

34. The exposure method according to claim 32, wherein the liquid recovery section is formed at the member.

35. A method for producing a device, comprising:

exposing a substrate by using the exposure method as defined in claim 31;
developing the exposed substrate; and
processing the developed substrate.

Fig. 1

**Fig. 2**

Fig. 3

EP 1 873 815 A1

# Fig. 4

EP 1 873 815 A1

Fig. 5

# Fig. 6

# Fig. 7

(A)

```
-- AX
     K1   LQ                                    70
                          ▨▨▨▨▨▨▨▨▨▨▨▨▨       22
     LR         LG              25          P
```

(B)

Fp: FILM APPEARANCE POSITION

SEPARATE

```
-- AX
              LQ    22B        FILM              70
     K1            LG                           22A
                  ▨▨▨▨▨▨▨▨▨▨▨▨▨▨▨              H
     LR                         22   25        P

              ⟹ SCANNING MOVEMENT

        ◄─────────── Lw ───────────►
     ◄─────────────── Ls ───────────────►
```

```
    Z
    ↑
    │
    └──► Y
```

**Fig. 8**

**Fig. 9**

## Fig. 10

Fig. 11

EP 1 873 815 A1

# Fig. 12

EP 1 873 815 A1

# Fig. 13

201 — DESIGN (FUNCTION, PERFORMANCE, PATTERN)

203 — SUBSTRATE PRODUCTION

202 — MASK PRODUCTION

204 — SUBSTRATE PROCESSING

205 — DEVICE ASSEMBLING

206 — INSPECTION

(SHIPPING)

## INTERNATIONAL SEARCH REPORT

International application No.

PCT/JP2006/306809

A. CLASSIFICATION OF SUBJECT MATTER
**H01L21/027**(2006.01), **G03F7/20**(2006.01)

According to International Patent Classification (IPC) or to both national classification and IPC

B. FIELDS SEARCHED

Minimum documentation searched (classification system followed by classification symbols)
H01L21/027, G03F7/20

Documentation searched other than minimum documentation to the extent that such documents are included in the fields searched
Jitsuyo Shinan Koho       1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2004-207711 A (Nikon Corp.), 22 July, 2004 (22.07.04), Par. Nos. [0035] to [0040]; all drawings & WO 2004/053956 A1    & AU 2003-289271 A1 | 1-3,5-7,10, 13-14,22-24, 26-27,29-33, 35 |
| Y | & EP 1571698 A1          & US 2005-237504 A1 & TW 2004-23226 A | 11-12,15-16, 18-21,28,34 |
| A | | 4,8-9,17,25 |
| Y | JP 2005-19864 A (Canon Inc.), 20 January, 2005 (20.01.05), Par. Nos. [0139] to [0142]; all drawings & US 2004-263809 A1 | 1-12,15-16, 18,28,34 |

☒ Further documents are listed in the continuation of Box C.          ☐ See patent family annex.

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T"  later document published after the international filing date or priority date and not in conflict with the application but cited to understand the principle or theory underlying the invention

"X"  document of particular relevance; the claimed invention cannot be considered novel or cannot be considered to involve an inventive step when the document is taken alone

"Y"  document of particular relevance; the claimed invention cannot be considered to involve an inventive step when the document is combined with one or more other such documents, such combination being obvious to a person skilled in the art

"&"  document member of the same patent family

| Date of the actual completion of the international search 31 May, 2006 (31.05.06) | Date of mailing of the international search report 06 June, 2006 (06.06.06) |
|---|---|
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/306809

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2005-5713 A  (ASML Netherlands B.V.),<br>06 January, 2005 (06.01.05),<br>Par. No. [0057]; Fig. 4<br>& EP 1486827 A2          & KR 2004-106242 A<br>& US 2005-225734 A1      & CN 1637608 A<br>& SG 118281 A1 | 19-21 |
| A | JP 2004-320016 A  (Nikon Corp.),<br>11 November, 2004 (11.11.04),<br>Full text; Fig. 2<br>(Family: none) | 4,25 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9949504 A
- JP 2004207710 A
- EP 1420298 A
- WO 2004055803 A
- WO 2004057589 A
- WO 2004057590 A
- WO 2005029559 A
- WO 2004019128 A
- JP 10163099 A
- JP 10214783 A
- US 6341007 B
- US 6400441 B
- US 6549269 B
- US 6590634 B
- JP 2000505958 A
- US 5969441 A
- US 6208407 B
- JP 11135400 A
- JP 2000164504 A
- US 6778257 B
- WO 2001035168 A